(19) **Europäisches Patentamt / European Patent Office / Office européen des brevets**

(11) **EP 1 676 141 B1**

(12) **EUROPÄISCHE PATENTSCHRIFT**

(45) Veröffentlichungstag und Bekanntmachung des Hinweises auf die Patenterteilung:
**11.04.2007   Patentblatt 2007/15**

(21) Anmeldenummer: **04790035.2**

(22) Anmeldetag: **22.10.2004**

(51) Int Cl.:
**G01R 31/3193** *(2006.01)*

(86) Internationale Anmeldenummer:
**PCT/DE2004/002362**

(87) Internationale Veröffentlichungsnummer:
**WO 2005/040839 (06.05.2005 Gazette 2005/18)**

(54) **AUSWERTESCHALTUNG UND VERFAHREN ZUM FESTSTELLEN UND/ODER ZUM LOKALISIEREN FEHLERHAFTER DATENWORTE IN EINEM DATENSTROM**

EVALUATION CIRCUIT FOR DETECTING AND/OR LOCATING FAULTY DATA WORDS IN A DATA STREAM

CIRCUIT D'EVALUATION, ET PROCEDE POUR DETERMINER ET/OU LOCALISER DES MOTS DE DONNEES INCORRECTS DANS UN FLUX DE DONNEES

(84) Benannte Vertragsstaaten:
**DE FR GB**

(30) Priorität: **24.10.2003   DE 10349933**

(43) Veröffentlichungstag der Anmeldung:
**05.07.2006   Patentblatt 2006/27**

(73) Patentinhaber: **Infineon Technologies AG**
**81669 München (DE)**

(72) Erfinder:
- **GOESSEL, Michael**
  **15831 Mahlow (DE)**
- **LEININGER, Andreas**
  **80469 München (DE)**
- **MATTES, Heinz**
  **81739 München (DE)**
- **SATTLER, Sebastian**
  **81541 München (DE)**

(74) Vertreter: **Schäfer, Horst**
**Schweiger & Partner**
**Patent- und Rechtsanwälte**
**Karlstrasse 35**
**80333 München (DE)**

(56) Entgegenhaltungen:
**US-A- 5 831 992**

- **SIGNATURE ANALYSIS FOR IDENTIFYING FAILING VECTORS, ITG-GMM, 15. WORKSHOP, TESTMETHODS AND RELIABILITY OF CIRCUITS AND SYSTEMS, [Online] 25. März 2003 (2003-03-25), XP002317738 BREMEN, GERMANY ITG-GMM, 15. Workshop, Testmethods and Reliability of Circuits and Systems Gefunden im Internet: URL:http://www.item.uni-bremen.de/itg-fg5/ workshop_15/paper/goessel_ analyzingFailing Vectors.pdf> [gefunden am 2005-02-15]**
- **GOESSEL M ET AL: "A PARITY-PRESERVING MULTI-INPUT SIGNATURE ANALYZER AND ITS APPLICATION FOR CONCURRENT CHECKING AND BIST" JOURNAL OF ELECTRONIC TESTING, KLUWER ACADEMIC PUBLISHERS, DORDRECHT, NL, Bd. 8, Nr. 2, 1. April 1996 (1996-04-01), Seiten 165-176, XP000598709 ISSN: 0923-8174**

**Beschreibung**

Integrierte Schaltungen, insbesondere schnelle digitale Schnittstellenschaltungen/Interfaces werden häufig schon während des Herstellungsverfahrens einem oder mehreren Produktionstests unterzogen, bei dem bzw. bei denen Testmuster/Testpattern an die integrierte Schaltung angelegt und der in Abhängigkeit dieser Testmuster von der integrierten Schaltung erzeugte Datenstrom untersucht werden.

Produktionstests, bei denen fehlerhafte integrierte Schaltungen zuverlässig entdeckt und rechtzeitig aussortiert werden können, dauern verhältnismäßig lange und erfordern einen hohen Aufwand.

Bei gängigen Produktionstests, bei denen aus Zeit- und Kostengründen die Datenströme komprimiert oder kompaktiert werden, ist es oft nicht möglich, fehlerhafte integrierte Schaltungen bereits während eines Produktionstests zu ermitteln, so dass fehlerhafte integrierte Schaltungen oft noch weitere Fertigungsstationen durchlaufen, bis sie als fehlerhaft identifiziert werden. Wenn fehlerhafte integrierte Schaltungen nicht während des oder der Produktionstests, sondern erst zu einem späteren Zeitpunkt im Herstellungsverfahren erkannt werden, entstehen bspw. bedingt durch die verringerte Produktionsausbeute hohe Kosten.

Gössel M. et al: "SIGNATURE ANALYSIS FOR IDENTIFYING FAILING VECTORS" ITG-GMM, 15. WORKSHOP, 25. März 2003 offenbart ein Verfahren zum Feststellen und/oder zum Lokalisieren von fehlerhaften Datenworten in enem Datenstrom mittels einer linearen Automatenschaltung.

Wenn bei mit komprimierten oder kompaktierten Datenströmen arbeitenden Produktionstests ein fehlerhafte Schaltung erkannt worden ist, so kann noch keine Aussage darüber getroffen wer-den, welche Stelle oder welcher Bereich diesen Fehler verursacht hat. Dies muss durch Aussortieren der fehlerhaften Schaltung sowie durch einen separaten Testlauf festgestellt werden.

Es ist Aufgabe der vorliegenden Erfindung, eine Vorrichtung sowie ein Verfahren bereitzustellen, mit dem bzw. mit der eine produktionsbegleitende Überprüfung von integrierten Schaltungen ermöglicht wird, bei der vorhandene Fehler in den getesteten Schaltungen zuverlässig erkannt und genau lokalisiert werden können.

Diese Aufgabe wird mit dem Gegenstand der unabhängigen Patentansprüche gelöst. Vorteilhafte Weiterbildungen der Erfindung ergeben sich aus den jeweiligen Unteransprüchen.

Die erfindungsgemäße Auswerteschaltung ist zum Feststellen und/oder zum Lokalisieren von fehlerhaften Datenworten in einem Datenstrom $T_n$ vorgesehen. Sie weist eine erste lineare Automatenschaltung sowie eine parallel geschaltete zweite lineare Automatenschaltung mit jeweils einer Menge von Zuständen z(t) auf. Bei diesen linearen Automatenschaltungen handelt es sich insbesondere um linear rückgekoppelte Schieberegistern mit einer Multiple-Input-Linear-Feedback-Shift-Register-Architektur/MILFSR- Architektur.

Beide lineare Automatenschaltungen sind mit einer gemeinsamen Eingangsleitung zur Aufnahme eines Datenstroms $T_n$ aus n aufeinanderfolgenden, jeweils k Bit breiten Datenwörtern y(1), ..., y(n) ausgestattet. An diese Eingangsleitung können beliebige Testdaten angelegt werden, wobei die Gutsignatur der idealen fehlerfreien Testdaten bekannt sein muss. Die erste lineare Automatenschaltung ist durch die Gleichung

$$z\left(t+1\right) = Az(t) \oplus y(t)$$

und die zweite lineare Automatenschaltung durch die Gleichung.

$$z\left(t+1\right) = Bz(t) \oplus y(t)$$

beschrieben. Dabei stellen A und B die Zustandsmatrizen der linearen Automatenschaltungen dar.

Die beiden linearen Automatenschaltungen können eine erste Signatur S1 bzw. eine zweite Signatur S2 berechnen, entweder direkt aus den Datenwörtern y(1), ..., y(n) des Datenstroms $T_n$ oder ggf. aus bereits kodierten Datenwörtern $u^1(1)$, ..., $u^1(n)$ bzw. $u^2(1)$, ..., $u^2(n)$ .

Unter Signatur wird in diesem Dokument eine Kompaktierung einer Menge von Datenwörtern verstanden. Aus diesen Signaturen ist es möglich, auf die fehlerhaften Datenwörter zurückzurechnen.

Diese berechneten Signaturen S1 und S2 werden durch ein nach der ersten linearen Automatenschaltung angeordnetes erstes Verknüpfungsgatter sowie durch ein nach der zweiten linearen Automatenschaltung angeordnetes zweites Verknüpfungsgatter jeweils mit einer fehlerfreien Gutsignatur verglichen. An den Ausgängen der Verknüpfungsgatter kann ein Vergleichswert mit den Gutsignaturen abgegriffen werden, mittels dessen ein Rückschluss darauf möglich ist, ob der betrachtete Datenstrom $T_n$ kein, ein oder mehrere fehlerhafte Datenwörter y'(i) aufweist.

Gemäß einem Grundgedanken der Erfindung kann aus den Signaturen eines Datenstroms $T_n$ somit direkt auf die Anzahl der fehlerhaften Datenworte y'(i) im Datenstrom $T_n$ geschlossen werden.

Falls im Datenstrom $T_n$ genau ein fehlerhaftes Datenwort y'(i) in der i-ten Position des Datenstromes vorhanden ist, das sich von dem fehlerfreien Datenwort y(i) um das nachfolgend auch einfach als Fehler bezeichnete Fehlerwort e(i), $y'(i) = y(i) \oplus e(i)$, unterscheidet, wobei mit $\oplus$ die komponentenweise Addition modulo 2 bezeichnet ist, ist es erfindungsgemäß möglich, die Position i des fehlerhaften Datenwortes y'(i) im Datenstrom und den Fehler e(i) direkt aus den Differenzen der Signaturen S1 und S2 von den entsprechenden fehlerfreien Signaturen zu bestimmen.

Die bei einem Produktionstest ständig an eine Ausgabeeinheit zu übertragenden und zu untersuchenden Testmuster reduzieren sich daher erfindungsgemäß um mehrere Größenordnungen. Es ist für die Fehlerlokalisierung nicht mehr nötig, einen Vergleich aller Datenworte mit den jeweils bekannten fehlerfreien Datenworten, also insgesamt 2 mal n Datenworten durchzuführen.

Es ist ebenfalls möglich, eine produktionsbegleitende Fehlerstatistik zu führen und auszuwerten, um festzustellen, ob fehlerhafte Bauteile durch einen derart reduzierten Datenstrom zu detektieren sind.

In einer ersten Ausführungsform der Auswerteschaltung, sind die Verknüpfungsgatter als exklusive Oder-Gatter ausgebildet, deren erster Eingang jeweils mit dem Ausgang der zugehörigen linearen Automatenschaltung verbunden ist und an deren zweiten Eingang eine Gutsignatur anzulegen ist.

Gemäß der Erfindung wird der Datenstrom $T_n$ aus n Datenworten in zwei unterschiedlichen, linear rückgekoppelten Schieberegistern mit k parallelen Eingängen zu zwei Signaturen S1 und S2 kompaktiert. Aus den beiden bekannten Gutsignaturen GS1 und GS2 der beiden Schieberegister für den fehlerfreien Datenstrom $T_n$ ergeben sich durch eine exklusive Oder-Verknüpfung mit den tatsächlich bestimmten Signaturen S1 und S2 die Signaturdifferenzen $\Delta S1 = GS1 \oplus S1$ und $\Delta S2 = GS2 \oplus S2$. Aus diesen Signaturdifferenzen $\Delta S1$ und $\Delta S2$ sind für den Fall, dass nur ein Datenwort im Datenstrom fehlerhaft ist, die Position i des fehlerhaften Datenwortes y'(i) im Datenstrom $T_n$ und das Fehlerwort e(i), das die Abweichung des fehlerhaften Datenwortes y'(i) vom korrekten Datenwort y(i), $y'(i) = y(i) \oplus e(i)$ beschreibt, bestimmt .

Liegen Fehler in zwei oder mehreren, beliebig vielen Datenworten vor, so ergibt sich aus den Signaturdifferenzen $\Delta S1$ und $\Delta S2$ als Ergebnis der erfindungsgemäßen Auswerteschaltung, dass der Datenstrom $T_n$ fehlerhaft ist.

In einer zweiten Ausführungsform der Erfindung verfügt die Auswerteschaltung über einen vor der ersten linearen Automatenschaltung angeordneten ersten Kodierer. Dieser kodiert das Datenwort y(i) mit der Datenwortlänge von k Bit für i=1, ..., n in ein kodiertes Datenwort $u^1(i)$, $u^1(i) = Cod1(y(i))$ der Wortbreite von K1 Bit. Cod1 ist dabei die Kodierungsfunktion des ersten Kodierers.

Dabei kann die Kodierfunktion Cod1 des ersten Kodierers so beschaffen sein,

- dass für y'(i) = y(i) $\oplus$ e(i) eine Funktion $f_1$ mit $f_1(0) = \overline{0}$ existiert,
- dass Codl(y'(i)) - Cod1(y(i) $\oplus$ e(i)) - Cod1(y(i) $\oplus$ $f_1$(e(1)) bzw. Cod1 (y' (i) ) - $u^1$(i) $\oplus$ $f_1$(e (1)) gilt

- und dass es eine Funktion $f_1^{-1}$, mit $f_1^{-1}(f_1(e)) = e$ für alle möglichen k-stelligen Binärwörter e gibt, wobei e ein Fehlerwort ist, um das ein fehlerhaftes Datenwort im Datenstrom $T_n$ von einem korrekten Datenwort abweichen kann.

In einer weiteren Ausführungsform der Erfindung verfügt die Auswerteschaltung über einen vor der zweiten linearen Automatenschaltung angeordneten zweiten Kodierer. Dieser kodiert das Datenwort y(i) mit der Datenwortlänge von k Bit für i=1, ..., n in ein kodiertes Datenwort $u^2(i)$, $u^2(i) = Cod2(y(i))$ der Wortbreite von K2 Bit. Dabei ist Cod2 die Kodierungsfunktion des zweiten Kodierers.

Die Kodierfunktion Cod2 des zweiten Kodierers kann dabei so beschaffen sein,

- dass für y'(i) gilt y'(i)= y(i) $\oplus$ e(i)) = Cod2(y(i)) $\oplus$ $f_2$(e(i)) bzw. Cod2(y'(i)) = $u^2$(i) $\oplus$ $f_2$(e(i))

- und dass eine Funktion $f_2^{-1}$ mit $f_2^{-1}$ (f₂(e)) =e existiert.

Die Kodierer können auch als durchgezogene Leitungen realisiert sein und eine identische Abbildung bewirken:

```
Cod1(y(i))=Cod2(y(i)))=y(i) für i=1, ..., n
```

Diese Ausgestaltung entspricht der bereits beschriebenen Auswerteschaltung ohne Kodierer.

Die Auswertung wird vereinfacht, wenn die Wortbreite K1 der von dem ersten Kodierer kodierten Datenwörter $u^1(i)$ gleich der Wortbreite K2 der von dem zweiten Kodierer kodierten Datenwörter $u^2(i)$ ist, wenn der erste Kodierer hinsichtlich seines Aufbaus und seiner Funktion mit dem zweiten Kodierer übereinstimmt und wenn die Wortbreite K1 der von dem ersten Kodierer kodierten Datenwörter $u^1(i)$ und die Wortbreite K2 der von dem zweiten Kodierer kodierten Datenwörter $u^2(i)$ jeweils gleich der Wortbreite k der Datenwörter y(1), ..., y(n) des Datenstroms $T_n$ ist.

In einer vorteilhaften Weiterbildung der Erfindung können die Kodierungsfunktionen Cod1 und Cod2 des ersten Kodierers und des zweiten Kodierers wie folgt ausgebildet sein:

$$\text{Cod1}(y_1(i),\ y_2(i),\ ...,\ y_k(i))$$
$$= P1(y_1(i),\ y_2(i),\ ...,\ y_k(i),\ 0,\ ...,\ 0)$$

$$\text{Cod2}(y_1(i),\ y_2(i),\ ...,\ y_k(i))$$
$$= P2(y_1(i),\ y_2(i),\ ...,\ y_k(i),\ 0,\ ...,\ 0)$$

für i, 1, ..., n

Dabei ist die Anzahl der am Ende von $P1(y_1(i), y_2(i), ..., y_k(1), 0, ...,0)$ befindlichen Nullen gleich (K1-k), und die Anzahl der am Ende von $P2(y_1(i), y_2(i), ..., y_k(i), 0, ...,0)$ ist gleich (K2-k). P1 stellt eine beliebige Permutation der K1 Komponenten von $(y_1(i), y_2(i), ..., y_k(i), 0, ..., 0)$, und P2 eine beliebige Permutation der K2 Komponenten von $(y_1(i), y_2(i), ..., y_k(1), 0, ...,0)$ dar.

In die K1=K2=k+1 Bit breiten Zustandsvektoren der linearen Automatenschaltungen werden in diesem Fall nur k Bit von $y_1(i), ..., y_k(i)$ über XOR-Elemente eingegeben. Für die Eingabe der konstanten Werte 0 sind keine XOR-Elemente erforderlich. Dadurch wird eine einfache Anpassung der Wortbreite der Datenwörter an die Wortbreite der Zustände gewährleistet.

Praktisch werden dabei in das k-Bit Datenwort $y_1(i), ..., y_k(i) = y(i)$ an (K1-k) Stellen bzw. an (K2-k) Stellen Nullen eingefügt. Die Komponenten können dabei durch die Permutationen noch vertauscht werden. Dadurch wird die Dimension der linearen Automatenschaltungen gleich K1>k, K2>k. Die Wahrscheinlichkeit eines falsch erkannten Fehlers wird damit geringer.

In einer alternativen Ausprägung der Auswerteschaltung sind die Kodierungsfunktionen Cod1 und Cod2 des ersten Kodierers und des zweiten Kodierers wie folgt ausgebildet:

$$\text{Cod1}(y_1(i), y_2(i),\ ...,\ y_k(i))$$
$$= P1(y_1(i),\ y_2(i),\ ...,\ y_k(i),\ b_1^1....,b_{K1-k}^1)$$

$$\text{Cod2}(y_1(i), y_2(i),\ ...,\ y_k(i))$$
$$= P2(y_1(i),\ y_2(i),\ ...,\ y_k(i),\ b_1^2....,b_{K2-k}^2)$$

mit $b_1^1,...,b_{K1-k}^1, b_1^2,...,b_{K2-k}^2 \in \{0,1\}$. P1 und P2 stellen dabei beliebige Permutationen dar. Bei der praktischen Umsetzung dieser Ausprägung der Erfindung werden in das Datenwort $y_1(i)....,y_k(i)=y(i)$ an K1-k (K2-k) Stellen Nullen und Einsen eingefügt.

Besonders vorteilhaft ist es, wenn die Kodierungsfunktion Cod1 des ersten Kodierers und/oder die Kodierungsfunktion Cod2 des zweiten Kodierers so ausgebildet sind, dass sie einen linearen Blockkode, $f_1$=Cod1 bzw. $f_2$=Cod2, realisieren. Dem Fachmann bekannte lineare Blockkodes können bspw. als Hamming-Kodes, als Paritätsbit-Kodes oder als Gruppen-Paritätsbit-Kodes ausgebildet sein.

Das Feststellen und das Lokalisieren fehlerhaften Datenworte in einem Datenstrom $T_n$ kann dadurch vereinfacht werden, indem die linearen Automatenschaltungen so gewählt werden, dass ihre Zustandsmatrizen A und B wie folgt miteinander in Beziehung stehen:

$$B = A^n, \ \text{mit } n \neq 1,$$

oder wenn die Zustandsmatrix B der zweiten linearen Automatenschaltung gleich der invertierten Zustandsmatrix $A^{-1}$ der ersten linearen Automatenschaltung ist

$$B = A^{-1}$$

In einer weiteren Ausführungsform der Auswerteschaltung liegen die erste lineare Automatenschaltung als linear rückgekoppeltes Schieberegister und die zweite lineare Automatenschaltung als inverses linear rückgekoppeltes Schieberegister vor. Dabei weisen beide linearen Automatenschaltungen eine parallele Eingabe auf.

Die linearen Automatenschaltungen können auch als linear rückgekoppelte, K1-dimensionale bzw. K2-dimensionale Multi-Input-Schieberegister, insbesondere maximale Länger vorliegen.

Die Erfindung betrifft auch ein Verfahren zum Feststellen fehlerhafter Datenworte y'(i) in einem Datenstrom $T_n$ aus n Datenwörtern y(1), ..., y(i-1), y'(i), y(i+1), ..., y(n) der Datenwortbreite k und/oder zum Lokalisieren eines fehlerhaften Datenworts y'(i) und einer fehlerhaften Position i eines fehlerhaften Datenworts y'(i) = y(i) $\oplus$ e(i).

Der Datenstrom $T_n$ weicht dabei in der i-ten Position von dem korrekten Datenstrom y(1), ..., y(i-1), y(i), y(i+1), ..., y(n) um e(i) ab.

Dabei werden zunächst die Datenwörter des Datenstromes $T_n$ in einen ersten Kodierer mit der Kodierfunktion Cod1 und der Dekodierungsfunktion Decod1 eingegeben. Der erste Kodierer kodiert die Datenwörter y(1), ..., y(i-1), y'(i), y(i+1), ..., y (n) in die kodierten Datenwörter $u^1(1)$, ..., $u^1(i-1)$, $u^{1'}(i)$, $u^1(i)$, ..., $u^1(n)$ der Wortbreite K1 mit K1$\geq$k.

Für y'(i) = y(i) $\oplus$ e(i) existiert eine Funktion $f_1$ derart, dass $f_1(0)$=0 und Cod1(y'(1)) = Cod1(y(i) $\oplus$ e(i)) = Cod1

(y(i) $\oplus$ $f_1$(e(i)) gilt und dass es eine Funktion $f_1^{-1} \ (f(e)) = e$ für alle prinzipiell möglichen k-stelligen Fehler mit

$f_1^{-1}(f_1(e))$ gibt.

Dann werden die derart kodierten Datenwörter in die Eingänge einer ersten linearen Automatenschaltung mit K1-dimensionalem Zustandsvektor $z^1$ eingegeben.

Die erste lineare Automatenschaltung ist durch die Automatengleichung

$$z^1(t+1) = A \cdot z^1(t) + u^1(t) \qquad \qquad (\text{I})$$

beschrieben. Ihre Matrix A ist als K1xK1 Matrix mit binärem Koeffizienten ausgebildet, so dass eine inverse Matrix $A^{-1}$ existiert und die Additionen und Multiplikationen in (1) modulo 2 erfolgen.

Die erste lineare Automatenschaltung geht bei Eingabe von y(1), ..., y(i-1), y(i), y(i+1), ... y(n) in den Kodierer und damit bei Eingabe von $u^1(1)$, ..., $u^1(i-1)$, $u^1(i)$, $u^1(i+1)$, ..., $u^1(n)$ in die erste lineare Automatenschaltung in den Zustand $z^1(n+1)$ = S(L1, y(1), ..., y(i-1), y(i), y(i+1), ..., y(n)) über.

Bei Eingabe der in der i-ten Position fehlerhaften Eingabe y(1), ..., y(i-1), y'(i), ..., y(n) in den Kodierer und damit bei Eingabe von $u^1(1)$, ..., $u^1(i-1)$, $u^{1'}(i)$, ..., $u^1(n)$ in die erste lineare Automatenschaltung geht diese in den Zustand $z^{1'}(n+1)$=S(L1, y(1), ..., y(i-1), y'(i), y(i+1), ..., y(n)) über.

Dabei sind die Signaturen der korrekten und der fehlerhaften Datenfolge jeweils mit S(L1, y(1), ..., y(i-1), y(i), y(i+1), ..., y(n)) und mit S(L1, y(1), ..., y(i-1), y'(i), y(i+1), ..., y(n)) bezeichnet.

Diese Signatur des Datenstroms $T_n$ kann mit einer bekannten Gutsignatur verglichen werden. Ergibt dieser Vergleich keine auf wenigstens ein fehlerhaftes Datenwort y'(i) hindeutende Abweichung, so ist der Datenstrom $T_n$ mit

hoher Wahrscheinlichkeit fehlerfrei. In diesem Fall wird das erfindungsgemäße Verfahren mit einem neuen Datenstrom $T_n$ wieder von vorne begonnen.

Wird hingegen eine auf wenigstens ein fehlerhaftes Datenwort y'(i) hindeutende Abweichung festgestellt, so fährt das Verfahren mit dem nächsten Verfahrenschritt fort, bei dem die Datenwörter y(1), ..., y(i-1), y'(i), ..., y(n) des Datenstromes $T_n$ in einem zweiten Kodierer mit der Kodierungsfunktion Cod2 und der Dekodierungsfunktion Decod2 eingegeben werden.

Die Eingabe des Datenstromes $T_n$ in den zweiten Kodierer erfolgt in der Praxis zumeist zeitgleich mit der Eingabe in den ersten Kodierer. Wenn der gleiche Datenstrom $T_n$ auch zweimal zeitversetzt zur Verfügung gestellt werden kann, kann die Eingabe in die Kodierer auch nacheinander erfolgen. Bei dieser Ausführungsform ist von Vorteil, dass nur ein Kodierer und nur eine lineare Automatenschaltung zur Verfügung stehen muss, die zweimal hintereinander für den gleichen Datenstrom $T_n$ zum Einsatz kommen.

Der zweite Kodierer und die zweite Automatenschaltung können dabei durch eine einfache Modifikation aus dem ersten Kodierer und aus der ersten Automatenschaltung erhalten werden.

Der zweite Kodierer kodiert die Datenwörter y(1), ..., y(i-1), y'(i), y(i+1), ..., y(n) in die kodierten Datenwörter $u^2(1)$, ..., $u^2(i-1)$, $u^{2'}(i)$, $u^2(i+1)$ der Datenwortbreite K2, K2$\geq$k.

Für y'(i) gilt dabei

$$\text{Cod2}(y'(i)) = \text{Cod2}(y(i) \oplus e(i)) = \text{Cod2}(y(i)) \oplus f_2(e(i))$$

Es existiert eine Funktion $f_2^{-1}$ mit $f_2^{-1}(f_2(e)) = e$.

Die derart kodierten Datenwörter werden in die Eingänge einer zweiten linearen Automatenschaltung mit K2-dimensionalem Zustandsvektor $z^2$ eingegeben. Dieser ist durch die folgende Automatengleichung beschrieben:

$$z^2(t+1) = B \cdot z^2(t) \oplus u^2(t) \qquad\qquad (VII)$$

Die Matrix B der zweiten linearen Automatenschaltung mit $B \neq A$ ist eine K2xK2-Matrix mit binärem Koeffizienten, für die eine inverse Matrix $B^{-1}$ existiert. Die Additionen und Multiplikationen in (VII) erfolgen modulo 2.

Die zweite lineare Automatenschaltung geht bei der Eingabe der korrekten Datenfolge y(1), ..., y(i-1), y(i), y(i+1), ..., y(n) in den zweiten Kodierer und bei Eingabe der kodierten Folge $u^1(1)$, ..., $u^1(i-1)$, $u^1(i)$, $u^1(i+1)$, ..., $u^1(n)$ in den Zustand $z^2(n+1)= S(L2, y(1), ..., y(i-1), y(i), y(i+1), ..., y(n))$ über.

Bei Eingabe der fehlerhaften Datenfolge y(1), ..., y(i-1), y'(i), y(i+1), ..., y(n) in den zweiten Kodierer und bei Eingabe der kodierten Folge $u^2(1)$, ..., $u^2(i-1)$, $u^{2'}(i)$, $u^2(i+1)$, ..., $u^1(n)$ in die zweite lineare Automatenschaltung geht diese in den Zustand $z^{2'}(n+1)= S(L2, y(1), ..., y(i-1), y(i), y'(i), y(i+1), ..., y(n))$ über.

Dabei sind die Signaturen der korrekten und der fehlerhaften Datenfolge jeweils mit S(L2, y(1), ..., y(i-1), y(i), y(i+1), ..., y(n)) und mit S(L2, y(1), ..., y(i-1), y'(i), ..., y(n)) bezeichnet.

Nun können die Signaturdifferenzen $\Delta$S1 und $\Delta$S2 bestimmt werden, und zwar aus den bestimmten Signaturen S1 und S2 und aus den vorgegebenen Gutsignaturen. Diese Berechnung der Signaturdifferenzen $\Delta$S1 und $\Delta$S2 erfolgt bspw. durch komponentenweise exklusive Oder-Verknüpfungen der Signaturen S1 und S2 mit den vorgegebenen Gutsignaturen.

Die Signaturdifferenzen $\Delta$S1 und $\Delta$S2 sind wie folgt definiert.

$$\Delta S1= \ \ S(L1, \ y(1), \ ..., \ y(i-1), \ y(i), \ y(i+1), \ ..., \ y(n)) \ \oplus$$
$$S(L1, \ y(1), \ ..., \ y(i-1), \ y'(i), \ y(i+1), \ ..., \ y(n))$$

und

$$\Delta S2 = \quad S(L2, \ y(1), \ ..., \ y(i-1), \ y(i), \ y(i+1), \ ..., \ y(n)) \quad \oplus$$

$$S(L2, \ y(1), \ ..., \ y(i-1), \ y'(i), \ y(i+1), \ ..., \ y(n))$$

Dabei werden die Signaturen komponentenweise XOR verknüpft.

Die folgenden Verfahrensschritte können von einer externen Berechnungseinheit, bspw. einem Computersystem unter Verwendung der bis zu diesem Zeitpunkt des Verfahrens bestimmten Werte vorgenommen werden.

Nun kann, falls genau ein fehlerhaftes Datenwort vorliegt, auf dessen Position i zurückgerechnet werden, und zwar indem eine eindeutige Lösung für die Position i des fehlerhaften Datenworts durch Lösen der Gleichung

$$f_1^{-1}(A^{i-n}\Delta S1) = f_2^{-1}(B^{i-n}\Delta S2) \qquad\qquad (XVI)$$

bestimmt wird. Der Wert der Position i kann aus der Gleichung (XVI) eindeutig bestimmt werden.

Falls sich keine eindeutige Lösung für i ergibt, wird durch ein Ausgabemedium eine Mitteilung ausgegeben, dass in dem betrachteten Datenstroms $T_n$ zwei oder mehr Fehler vorliegen.

Wenn der Wert der Position i berechnet worden ist, so kann auch eine eindeutige Lösung für alle Bits des fehlerhaften Datenworts e(i) im Datenstroms $T_n$ bestimmt werden, und zwar durch Lösen der Gleichung

$$e(i) = f_1^{-1}(A^{i-n} \cdot \Delta S1) \qquad\qquad (XIV)$$

Der Wert für e(i) ist aus der Gleichung (XIV) für den aus (XVI) bestimmten Wert für $i \in \{1,...,n\}$ festgelegt.

Die Position i des fehlerhaften Datenworts y'(i) sowie der Fehler e im Datenstrom $T_n$ können durch ein Ausgabemedium, bspw. durch einen Bildschirm oder durch einen Drucker zur Verfügung gestellt werden.

Die Verfahrensschritte des vorstehend beschriebenen Verfahrens können mit einer bereits beschriebenen, erfindungsgemäßen Auswerteschaltung durchgeführt werden, deren Ausgänge, an denen die Signaturdifferenzen $\Delta S1$ und $\Delta S2$ bereitgestellt werden, ggf. mit einer externen Berechnungseinheit, bspw. einem Computersystem verbunden ist, das die Rückberechnungsschritte durchführt.

Die Erfindung betrifft auch eine zu testenden integrierte Schaltung, auf der eine erfindungsgemäße Auswerteschaltung in einer der vorstehend beschriebenen Ausführungsformen, insbesondere zusätzlich zur normalen Schaltung quasi als add-on enthalten ist. Dabei ist die erfindungsgemäße Auswerteschaltung auf dem integrierten Schaltkreis oder auf dem Halbleiterbauteil monolithisch integriert.

Die Erfindung betrifft auch eine Nadelkarte zum Testen von integrierten Schaltungen, bei der eine erfindungsgemäße Auswerteschaltung in einer der vorstehend beschriebenen Ausführungsformen integriert ist.

Die Erfindung betrifft weiterhin ein testerspezifisches load board mit Testfassungen zum Einstecken von integrierten Schaltungen oder zur Aufnahme einer solchen Nadelkarte oder zum Anschluss eines handlers, wobei auf dem load board wenigstens eine erfindungsgemäße Auswerteschaltung in einer der vorstehend beschriebenen Ausführungsformen integriert ist. Ein solches load board kann auch als Adapterboard bezeichnet werden.

Die erfindungsgemäße Auswerteschaltung kann auch direkt auf einem Tester/ Messgerät/Testsystem/Testautomat zum Testen von integrierten Schaltkreisen integriert werden. Solch ein Tester verfügt über mehrere Instrumente zum Erzeugen von Signalen oder Datenströmen und über mehrere Mess-Sensoren, insbesondere für Ströme und Spannungen und weist ein Loadboard auf, das zur Aufnahme wenigstens einer Nadelkarte zum Testen von integrierten Schaltkreisen und/oder zum Anschluss eines Handlers an einen Tester von integrierten Schaltkreisen vorgesehen ist und/oder das mit wenigstens einem Testsockel zum Testen von integrierten Schaltkreisen ausgestattet ist.

Gemäß einem weiteren Grundgedanken der Erfindung kann die erfindungsgemäße Auswerteschaltung in allen vorstehend beschriebenen Ausführungsformen einfach und sehr platzsparend auf allen möglichen Schaltungen oder Geräten in jeder Abstraktionsebene bzw. auf jeder Messgeräteebene vorgesehen werden. Beeinträchtigungen der Funktionsweise ergeben sich dabei nicht. Die konkrete Ausgestaltung der vorstehend beschriebenen Gegenstände mit einer solchen Auswerteschaltung ergibt sich für den Fachmann vollständig und eindeutig aus den in dieser Patentschrift enthaltenen Informationen sowie aus seinem Fachwissen. Dabei ist lediglich zu beachten, dass die erfindungsgemäße Auswerteschaltung jeweils zusätzlich zu den auf den vorstehend genannten Gegenständen enthaltenen Schaltungen aufzubringen ist.

Die Erfindung wird auch in einem Computerprogramm zum Ausführen des Verfahrens zum Feststellen und/oder zum Lokalisieren fehlerhafter Datenworte in einem Datenstrom $T_n$ verwirklicht. Das Computerprogramm enthält dabei Programmanweisungen, die ein Computersystem veranlassen, ein solches Testverfahren in einer vorstehend beschriebenen Ausführungsform auszuführen.

Dabei werden insbesondere die Verfahrensschritte des Erzeugens und des Eingebens von Datenwörtern y(1), ..., y(i-1), y'(i), y(i+1), ..., y(n) eines Datenstroms $T_n$ in die Auswerteschaltung sowie die Rückberechnungsschritte auf die Position des fehlerhaften Datenworts y'(i) und des Fehlers e aus den Signaturdifferenzen $\Delta$S1 und $\Delta$S2 mit einem Computersystem gesteuert oder auf einem Computersystem selbst durchgeführt. Das Computerprogramm gibt die Ergebnisse als digitale Datenfolgen oder in einer daraus generierten Darstellungsform auf einer Ausgabeeinheit aus, insbesondere auf einem Bildschirm oder auf einem Drucker, oder speichert diese Ergebnisdaten in einem Speicherbereich. Durch das erfindungsgemäße Computerprogramm können fehlerhafte Datenworte schnell, effektiv und zuverlässig bestimmt werden, wobei sich eine deutliche Beschleunigung der Testlaufzeit ergibt.

Die Erfindung betrifft außerdem ein Computerprogramm, das auf einem Speichermedium, insbesondere in einem Computerspeicher oder in einem Direktzugriffsspeicher enthalten ist oder das auf einem elektrischen Trägersignal übertragen wird. Die Erfindung betrifft auch ein Trägermedium, insbesondere einen Datenträger, wie bspw. eine Diskette, ein Zip-Laufwerk, einen Streamer, eine CD oder eine DVD, auf denen ein vorstehend beschriebenes Computerprogramm abgelegt ist. Ferner betrifft die Erfindung ein Computersystem, auf dem ein solches Computerprogramm gespeichert ist. Schließlich betrifft die Erfindung auch ein Download-Verfahren, bei dem ein solches Computerprogramm aus einem elektronischen Datennetz, wie bspw. aus dem Internet, auf einen an das Datennetz angeschlossenen Computer heruntergeladen wird.

Die Erfindung ist in den Zeichnungen anhand eines Ausführungsbeispiels näher veranschaulicht.

Figur 1    zeigt eine erste Messdatenflussdarstellung mit n fehlerfreien Datenworten y(1), y(2), ..., y(n),

Figur 2    zeigt eine zweite Messdatenflussdarstellung mit einem fehlerhaften Messdatenwort y'(i),

Figur 3    zeigt eine schematische Darstellung einer ersten linearen Automatenschaltung,

Figur 4    zeigt eine schematische Darstellung einer zweiten linearen Automatenschaltung,

Figur 5    zeigt ein Ablaufschema zum Bestimmen von Signaturunterschieden $\Delta$S1 und $\Delta$S2 aus einem Messdatenstrom $T_n$,

Figur 6    zeigt ein Ablaufdiagramm zur Veranschaulichung des erfindungsgemäßen Verfahrens zum Feststellen eines Fehlers e(i) in einem Datenwort y(i).

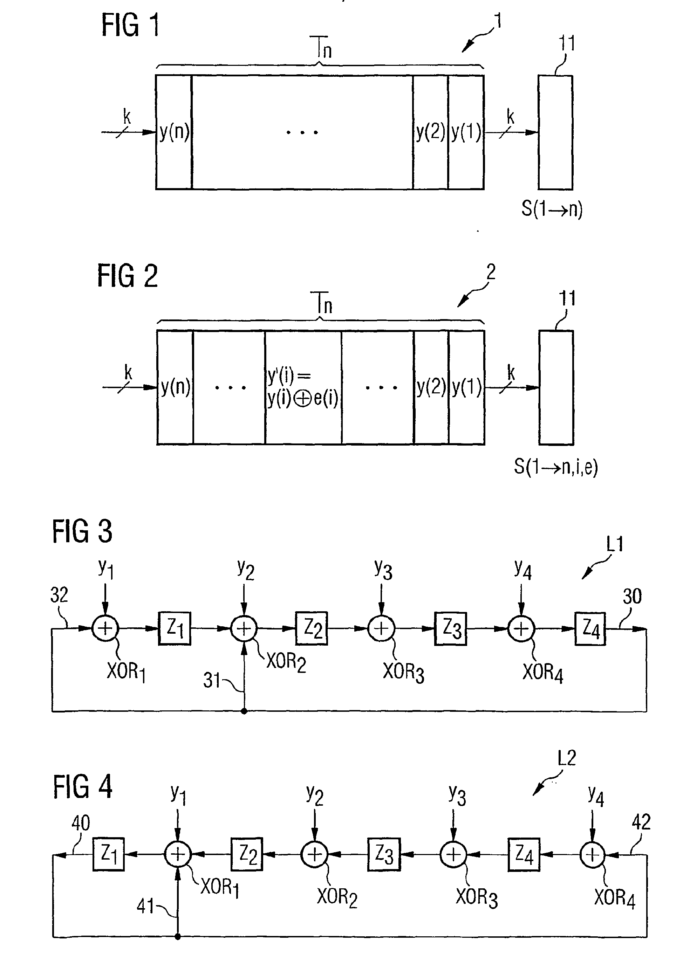

Figur 1 zeigt eine erste Messdatenflussdarstellung 1.

Die erste Messdatenflussdarstellung 1 umfasst einen in Figur 1 rechteckig dargestellten pseudo-zufälligen Messdatenstrom $T_n$, der sich in n aufeinanderfolgende Datenworte y(1), y(2), ..., y(n) mit jeweils einer gleichen Datenwortlänge von k Bit gliedert . Links der ersten Messdatenflussdarstellung 1 ist ein Eingang der Bitbreite k gezeigt, an dem die Messdatenworte y(1), y(2), ..., y(n) bspw. von einem getesteten integrierten Schaltkreis jeweils getaktet ausgegeben werden. Daher sind die Messdatenworte mit den höheren Indizes in Figur 1 weiter links angeordnet. Ein solcher getesteter integrierten Schaltkreis wird nachfolgend auch Device Under Test/DUT bezeichnet.

Rechts der ersten Messdatenflussdarstellung 1 ist ein Ausgang der Bitbreite k dargestellt, über den die Messdaten einem Schieberegister 11 zugeleitet werden. Bei dem Schieberegister 11 handelt es sich um ein Schieberegister mit einer Multiple-Input-Linear-Feedback-Shift-Register-Architektur bzw. mit einer MILFSR-Architektur. Durch das Schieberegister 11 sollen alle n Datenworte in einem einzigen Datenwort der Länge k Bit komprimiert werden. Die Vorschrift für die Abbildung von n Datenworten y(1), y(2), ..., y(n) in eine einzige Signatur ist in Gleichung (1) gegeben.

$$S(1 \rightarrow n) = S \; ( \, y(1) , \quad y(2) , \ldots , \quad y(n) ) \qquad\qquad (1)$$

Der Anfangszustand $z(t_0)$ des Schieberegisters 11 mit der MILFSR-Architektur ist durch den Nullvektor 0 gegeben, $z(t_0)=0$.

Figur 2 zeigt eine zweite Messdatenflussdarstellung 2 mit einem fehlerhaften Messdatenwort y'(i).

Die zweite Messdatenflussdarstellung 2 unterscheidet sich von der ersten Messdatenflussdarstellung 1 dadurch, dass ihr Datenstrom $T_n$ einen Fehler e(i) im i-ten Datenwort y'(i) des Datenstroms $T_n$ aufweist. Wenn ein solcher Fehler e(i) im Datenwort y'(i) des Datenstroms $T_n$ vorliegt, ist die Vorschrift für die Abbildung von n Datenworten y(1), y(2), ..., y(n) durch die Signatur des Schieberegisters 11 durch Gleichung (2) gegeben.

$$S(1 \rightarrow n, i, e) = S\ (\ y(1)\ ,\quad y(2)\ ,\quad \ldots,\quad e(i)\ ,\quad \ldots,\quad y(n)\ ) \qquad (2)$$

Diese Signatur wird mit dem Schieberegister 11 nun aus den Datenworten y(1), y(2), ..., e(i), ..., y(n) erzeugt. Das Schieberegister 11 weist die bereits mit Bezug auf Figur 1 erwähnte MILFSR-Architektur auf.

Durch geschickten Vergleich der Signaturen $S\ (y(1)\ ,\ y(2)\ ,\ ...,\ e(i)\ ,\ ...,\ y(n)\ )$ in Gleichung (1) und $S\ (y(1),\ y(2)\ ,\ ...,\ e(i)\ ,\ ...,\ y(n)\ )$ in Gleichung (2) kann auf die Position i des fehlerhaften Datenworts y'(i) und auf den Fehler e(i), d. h. auf alle seine fehlerhaften Bits e(i) zurückgerechnet werden.

Enthält eine bekannte digitale Testantwort eines DUT genau einen Fehler e(i) im i-ten Datenwort des Datenstroms, so können mit Hilfe der aus einer MILFSR Architektur berechneten Abbildung $S(1 \rightarrow n, i, e)$ das Datenwort y' (i) und alle fehlerhaften Bits seines Fehlers e(i) gewonnen werden. Dies geschieht zu einem Zeitpunkt t > n, an dem die Datenworte y(1), y(2), ..., y(n) des Datenstroms $T_n$ nicht mehr zur Verfügung stehen bzw. nicht mehr benötigt werden.

Gemäß der vorliegenden Erfindung brauchen für den Test, für die Diagnose und für die Fehlerkorrektur eines Fehlers in einem beliebigen Datenwort des Datenstroms $T_n$ aus n k-bit Datenworten nur 2 Signaturen, d.h. 2 k-bit Datenworte ausgewertet zu werden.

Figur 3 zeigt eine schematische Darstellung einer ersten linearen Automatenschaltung L1.

Die erste lineare Automatenschaltung L1 umfasst vier in Figur 3 rechteckig dargestellte und jeweils nacheinander angeordnete Zustände $z_1$, $z_2$, $z_3$ und $z_4$, die in Speicherelementen, bspw. D-Flip Flops gespeichert sind. Vor dem ersten Zustand $z_1$ und jeweils zwischen den Zuständen $z_2$, $z_3$ und $z_4$ sind vier exklusive Oder-Gatter $XOR_1$, $XOR_2$, $XOR_3$ und $XOR_4$ vorgesehen, deren erste Eingänge jeweils von vier Messdatenleitungen $y_1$, $y_2$, $y_3$ und $y_4$ gebildet werden und deren Ausgänge mit dem jeweils nachfolgenden Zuständen $z_1$, $z_2$, $z_3$ und $z_4$ verbunden sind.

Der zweite Eingang des zweiten Oder-Gatters $XOR_2$ ist mit dem Ausgang des ersten Zustands $z_1$ verbunden. Der zweite Eingang des dritten Oder-Gatters $XOR_3$ wird von dem Ausgang des zweiten Zustands $z_2$ gebildet. Den zweiten Eingang des vierten Oder-Gatters $XOR_4$ bildet der Ausgang des dritten Zustands $z_3$.

Am Ausgang des vierten Zustands $z_4$ setzt eine erste Ausgangsleitung 30 an, die sich in eine erste Rückkopplungsleitung 31 und in eine zweite Rückkopplungsleitung 32 gabelt. Die erste Rückkopplungsleitung 31 bildet den dritten Eingang des zweiten XOR-Gatters $XOR_2$, und die zweite Rückkopplungsleitung 32 bildet den zweiten Eingang des ersten XOR-Gatters $XOR_1$.

Die erste lineare Automatenschaltung L1 ist dementsprechend als ein mit einem primitiven Polynom rückgekoppelten Schieberegisters mit vier Zuständen $z_1$, $z_2$, $z_3$ und $z_4$ ausgebildet.

Die Zustandsgleichungen der ersten linearen Automatenschaltung L1 werden aus den Zuständen z(t+1) zum Zeitpunkt t+1 in Abhängigkeit der Zustände z(t) zum Zeitpunkt t berechnet. Für die erste lineare Automatenschaltung L1 gelten die Gleichungen (3) - (6):

$$z_1(t+1)\ =\ z_4(t)\ \oplus\ y_1(t) \qquad (3)$$

$$z_2(t+1)\ =\ z_1(t)\ \oplus\ z_4(t)\ \oplus\ y_2(t) \qquad (4)$$

$$z_3(t+1)\ =\ z_2(t)\ \oplus\ y_3(t) \qquad (5)$$

$$z_4(t+1)\ =\ z_3(t)\ \oplus\ y_4(t) \qquad (6)$$

Mit A als Zustandsmatrix ergibt sich:

$$z(t+1) =\ Az(t)\ \oplus\ y(t) \qquad (7)$$

mit

$$A = \begin{bmatrix} 0001 \\ 1001 \\ 0100 \\ 0010 \end{bmatrix}, \quad z(t+1) = \begin{bmatrix} z_1(t+1) \\ z_2(t+1) \\ z_3(t+1) \\ z_4(t+1) \end{bmatrix}, \quad z(t) = \begin{bmatrix} z_1(t) \\ z_2(t) \\ z_3(t) \\ z_4(t) \end{bmatrix}, \quad y(t) = \begin{bmatrix} y_1(t) \\ y_2(t) \\ y_3(t) \\ y_4(t) \end{bmatrix}$$

Das autonome Verhalten der ersten linearen Automatenschaltung L1 berechnet sich aus Gleichung (7) mit y (t)=0 zu

$$z(t+1) \;=\; Az(t) \tag{8}$$

Die Gleichungen (3) - (8) werden auch als Nachfolger-Gleichungen bezeichnet.
Aus den Gleichungen (3), (5) und (6) folgt mit $y_i(t) = 0$ für $i \in \{1,2,3,4\}$ :

$$z_4(t) \;=\; z_1(t+1) \tag{9}$$

$$z_2(t) \;=\; z_3(t+1) \tag{10}$$

$$Z_3(t) \;=\; z_4(t+1) \tag{11}$$

Aus Gleichung (9), eingesetzt in Gleichung (4) folgt:

$$z_2(t+1) \;=\; z_1(t+1) \;\oplus\; z_1(t)$$

und

$$z_1(t+1) \;\oplus\; z_2(t+1) \;=\; z_1(t+1) \;\oplus\; z_1(t+1) \;\oplus\; z_1(t)$$

Daraus ergibt sich:

$$z_1(t) \;=\; z_1(t+1) \;\oplus\; z_2(t+1) \tag{12}$$

Die Gleichungen (9) - (12) werden als Vorgänger-Gleichungen der linearen Automatenschaltung L1 für die Eingabe 0 oder auch als autonome Vorgänger-Gleichungen der linearen Automatenschaltung L1 bezeichnet.
In Matrizenschreibweise erhält man analog zu den Nachfolger-Gleichungen in (8) aus (9)-(12) die Vorgänger-

Gleichungen

$$z(t) = A^{-1} z(t+1) \qquad (13)$$

mit

$$A^{-1} = \begin{bmatrix} 1100 \\ 0010 \\ 0001 \\ 1000 \end{bmatrix}$$

$A^{-1}$ ist die Invertierte zu A. Die Multiplikation aus A und aus $A^{-1}$ ergibt die Einheitsmatrix E.

$$A^{-1} A = E \text{ mit } E = \begin{bmatrix} 1000 \\ 0100 \\ 0010 \\ 0001 \end{bmatrix} \qquad (14)$$

Figur 4 zeigt eine schematische Darstellung einer zweiten linearen Automatenschaltung L2.

Bezüglich der Signalrichtung ist die zweite lineare Automatenschaltung L2 spiegelbildlich zur ersten linearen Automatenschaltung L1 dargestellt.

Die zweite lineare Automatenschaltung L2 umfasst wie die erste lineare Automatenschaltung L1 vier Zustände $z_1$, $z_2$, $z_3$ und $z_4$, vier exklusive Oder-Gatter $XOR_1$, $XOR_2$, $XOR_3$ und $XOR_4$ sowie vier Messdatenleitungen $y_1$, $y_2$, $y_3$ und $y_4$, welche jeweils die ersten Eingänge der exklusiven Oder-Gatter $XOR_1$, $XOR_2$, $XOR_3$ und $XOR_4$ bilden.

Die exklusiven Oder-Gatter $XOR_1$, $XOR_2$, $XOR_3$ und $XOR_4$ befinden sich vor dem vierten Zustand $z_4$ und jeweils zwischen den Zuständen $z_1$, $z_2$ und $z_3$. Die Ausgänge der exklusiven Oder-Gatter $XOR_1$, $XOR_2$, $XOR_3$ und $XOR_4$ sind mit dem jeweils nachfolgenden Zuständen $z_1$, $z_2$, $z_3$ und $z_4$ verbunden.

Der Ausgang des ersten Zustands $z_1$ bildet eine zweite Ausgangsleitung 40, die sich in eine dritte Rückkopplungsleitung 41 und in eine vierte Rückkopplungsleitung 42 aufteilt. Die dritte Rückkopplungsleitung 41 fließt in das erste exklusive Oder-Gatter $XOR_1$ und die vierte Rückkopplungsleitung 42 in das vierte exklusive Oder-Gatter $XOR_1$ ein.

Wie die erste lineare Automatenschaltung L1 ist auch die zweite lineare Automatenschaltung L2 als ein mit einem primitiven Polynom rückgekoppeltes Schieberegisters mit vier Zuständen $z_1$, $z_2$, $z_3$ und $z_4$ ausgebildet.

Die Zustandsgleichung der zweiten linearen Automatenschaltung L2 ist in Gleichung (15) gegeben.

$$z(t+1) = B \; z(t) \; \oplus \; y(t) \qquad (15)$$

mit

$$B = \begin{bmatrix} 1100 \\ 0010 \\ 0001 \\ 1000 \end{bmatrix} = A^{-1} \qquad (16)$$

B ist die Invertierte von A.

Für einen angenommenen Fehler e(i) in einem k-bit Datenwort y'(i) des Datenstroms $T_n$ aus Figur 2 erhält man aus der Abbildungsvorschrift gemäß Gleichung (2)

$$S(1 \rightarrow n, i, e) = S\,(\,y(1)\,,\quad y(2)\,,\quad \ldots,\quad y(i) \oplus e(i)\,,\quad \ldots,\quad y(n)\,) \qquad (17)$$

und durch Anwendung des Superpositionsprinzips bei linearen Automaten

$$S(1 \rightarrow n, i, e) = S\,(\,y(1)\,,\quad y(2)\,,\quad \ldots,\quad y(n)\,)\quad \oplus\quad S(0,0,\ldots,e(i),\ldots,0)$$

bzw.

$$S(1 \rightarrow n, i, e) = S\,(1 \rightarrow n)\quad \oplus\quad S(0,0,\ldots,e(i),\ldots,0)$$

die Differenz

$$\Delta S1(i,e) = S(1 \rightarrow n, i, e)\quad \oplus\quad S(1 \rightarrow n) \qquad (18)$$

mit

$$\Delta S1(i,e) = S(0,0,\ldots,e(i),\ldots,0) \qquad (19)$$

für

$$y(t) = 0\,,\quad \text{für } t \neq i \quad \text{und} \quad y(t) = e(i)\,,\quad \text{für } t = i$$

Mit Gleichung (19) in Gleichung (18) folgt

$$\Delta S1(i,e) = S((n-i) \rightarrow n, i, e) \oplus S((n-i) \rightarrow n) \qquad (20)$$

Zum Zeitpunkt t = i-1 ist noch kein Fehler e(i) im Datenwort y'(i) aufgetreten; erst ab dem Zeitpunkt t=i tritt dieser Fehler e(i) in einem k-bit Datenwort auf.

Für die Bildung der Signatur aus n Datenworten y(1), y(2), ..., y(n) mit genau einem angenommenen Fehler e(i) in einem Datenwort y'(i) erhalten wir aus den Gleichungen (20) und (7)

$$\Delta S1(i,e) = A^{(n-1)}e(i); i \in \{1, 2, ..., n\} \qquad (21)$$

Gleichung (21) ist die Differenz von zwei MILFSR-Signaturen, nämlich von der Signatur eines 1-Wort fehlerhaften Datenstroms $T_n$ am Ort i und von der Signatur eines fehlerfreien Datenstroms $T_n$. Die Signaturdifferenz $\Delta S1(i, e)$ wird gebildet, indem das fehlerhafte Datenwort y'(i) den Anfangszustand der MILFSR Architektur definiert und dann (n-i)-mal in der MILFSR Architektur bei Eingabe von lauter 0-Vektoren akkumuliert wird.

Formt man nun Gleichung (21) mit Gleichung (16) um

$$e(i) = B^{(n-i)}\Delta S1(i,e) \qquad (22)$$

so wird erkennbar, dass das Datenwort e(i) als neue Signatur berechnet werden kann, indem der Anfangszustands der zweiten linearen Automatenschaltung L2 auf $\Delta S1(i,e)$ gesetzt und danach (n-i)-mal akkumuliert wird.

Erfindungsgemäß können invertierte MILFSR Architekturen also zur Berechnung von 1-Wort Fehlern e in Datenströmen $T_n$ verwendet werden, ohne dass es notwendig ist, diese Datenströme zum Zeitpunkt der Berechnung von e(i) noch zur Verfügung zu haben.

Aus der der Gleichung (20) entsprechenden Gleichung

$$\Delta S2(i,e) = B^{(n-i)}e(i) \qquad (23)$$

für die zweite lineare Automatenschaltung L2 erhalten wir mit Gleichung (16) analog zu Gleichung (20) die folgende Gleichung (24). Für einen angenommenen 1-Wort Fehler e(i) erhält man aus Gleichung (21) für die erste lineare Automatenschaltung L1

$$e(i) = A^{(n-i)}\Delta S2(i,e) \qquad (24)$$

Durch Gleichsetzen von Gleichung (22) und (24) ergibt sich

$$A^{(n-i)}\Delta S2(i,e) = B^{(n-i)}\Delta S1(i,e) \qquad (25)$$

Wenn also der Anfangszustand der ersten linearen Automatenschaltung L1 auf $\Delta S2(i,e)$ bzw. wenn der Anfangszustand der zweiten linearen Automatenschaltung L2 auf $\Delta S1(i,e)$ gesetzt wird und wenn dieser Wert (n-i)-mal akkumuliert wird, so ergibt sich der Fehler e(i) bei beiden linearen Automatenschaltungen L1 und L2 als neue Signatur bzw. als neuer Zustand.

Der Wert für die Position i des fehlerhaften Datenworts y'(i) muss dabei zwischen 1 und n liegen.

Ergibt sich für keinen der Werte i, $1 \leq i \leq n$ in Gleichung (25) die Gleichheit der Ausdrücke $A^{(n-i)}\Delta S2(i,e)$ und $B^{(n-i)}\Delta S1(i,e)$, so liegt kein Fehler e(i) vor, der nur die Position i des Datenworts verfälscht, sondern ein Fehler, der mindestens zwei unterschiedliche Positionen im Datenstrom verfälscht hat.

Ergibt sich $\Delta S1 \neq 0$, dann kann man durch Zurücksetzen der linearen Automatenschaltungen L1 und L2 auf $\Delta S2$ bzw. $\Delta S1$ und durch Vergleich der in jedem Schritt akkumulierten Signaturen die Position i des fehlerhaften Datenworts y'(i) und den Fehler e(i) nach n-i Schritten an beiden Signaturen bzw. Zuständen detektieren. Die Signaturen beider linearer Automatenschaltungen L1 und L2 sind in diesem Fall gleich

$$z^1(n-i) = z^2(n-i) \qquad (26),$$

wobei $z^1$ und $z^2$ L-dimensionale Zustandsvektoren der linearen Automatenschaltungen L1 und L2 sind, und wobei $z'(n-i)$ und $z'(n-i)$ die Zustände der beiden linearen Automatenschaltungen L1 und L2 nach n-i Takten sind.

Bei seriellem Dateninput gilt für die beiden linearen Automatenschaltungen L1 und L2

$$y_i(t) = 0 \quad \text{für} \quad i \neq 1 \quad \text{(L1)} \qquad (27)$$

$$y_i(t) = 0 \quad \text{für} \quad i \neq k \quad \text{(L2)} \qquad (28)$$

Dabei steht k für die Anzahl der Bits eines Datenwortes y(i) aus dem Datenstrom $T_n$.

Der Vergleich auf Identität der in dieser MILFSR Architektur zurückgerechneten Signaturen ergibt für einen angenommenen Fehler e im Datenwort i nach n-1 Schritten

$$z^1(n-i) = z^2(L+1-n+i) \qquad (29)$$

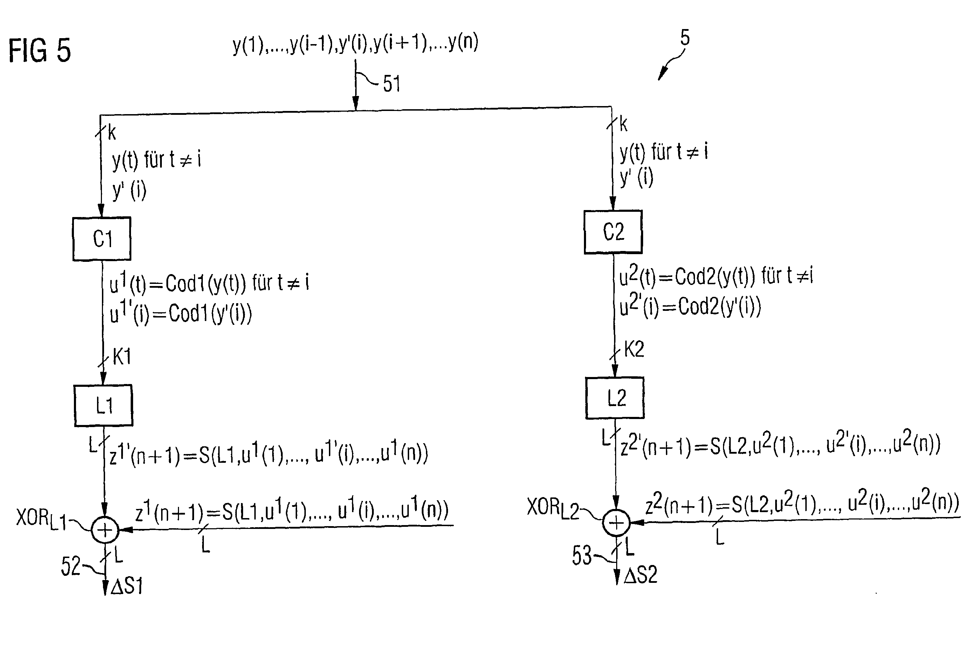

Figur 5 zeigt ein Ablaufschema 5 zum Bestimmen von Signaturunterschieden $\Delta S1$ und $\Delta S2$ aus einem Messdatenstrom $T_n$.

An der oberen Seite des Ablaufschemas 5 befindet sich eine Messdatenwortleitung 51, an der ein Datenstrom $T_n$ aus n aufeinanderfolgenden Datenwörtern y(1), ..., y(i-1), y'(i), y(i+1), ..., y(n) mit jeweils gleicher Datenwortlänge von k Bit anliegt. Dabei stellt das Datenwort y'(i) ein fehlerhaftes Datenwort dar.

Die Messdatenwortleitung 51 gabelt sich in zwei Äste, von denen der linke einen ersten Kodierer C1, die erste lineare Automatenschaltung L1, L-exklusive Oder-Gatter $XOR_{L1}$, die in Form eines XOR-Gatters der Wortbreite L zusammengefasst sind, sowie einen ersten Ausgang 52 aufweist, an dem der Signaturunterschied $\Delta S1$ ausgegeben wird. Der rechte Ast umfasst einen zweiten Kodierer C2, die zweite lineare Automatenschaltung L2, L-exklusive Oder-Gatter $XOR_{L2}$, die ebenfalls in Form eines XOR-Gatters der Wortbreite L zusammengefasst sind, sowie einen zweiten Ausgang 53, an dem der Signaturunterschied $\Delta S2$ ausgegeben wird.

Die jeweils L-ersten Eingänge der L-exklusiven Oder-Gatter $XOR_{L1}$ werden von den Ausgängen der ersten linearen Automatenschaltung L1, und die ersten Eingänge der L-exklusiven Oder-Gatter $XOR_{L2}$ werden von den Ausgängen der zweiten linearen Automatenschaltung L2 gebildet.

An den zweiten Eingängen der L-exklusiven Oder-Gatter $XOR_{L1}$ und $XOR_{L2}$ werden durch in Figur 5 nicht gezeigte digitale Schaltungen Gutsignaturen der beiden linearen Automatenschaltungen L1 und L2 bereitgestellt. Diese Gutsignaturen können für einen bekannten Datenstrom $T_n$ bestimmt werden. Dies ist dem Fachmann bekannt.

Der Messdatenstrom $T_n$ wird über den ersten Kodierer C1 in die erste lineare Automatenschaltung L1 und parallel dazu über den zweiten Kodierer C2 in die zweite lineare Automatenschaltung L2 eingegeben.

Durch die Kodierer C1 und C2 wird der jeweils anliegende Datenstrom $T_n$ einheitlich transformiert. Dadurch ist es möglich, auch Datenwörter y(1), ..., y(n) verschiedener Datenströme $T_n$ miteinander zu vergleichen.

Durch die linearen Automatenschaltungen L1 und L2 werden die durch die Kodierer C1 und C2 kodierten Datenwörter $u^1(1)$, ..., $u^1(n)$ bzw. $u^2(1)$, ..., $u^2(n)$ zu Signaturen S1 und S2 kompaktiert.

Die so bestimmten tatsächlichen Signaturen S1 und S2 werden danach in den exklusiven Oder-Gattern $XOR_{L1}$ und $XOR_{L2}$ mit den bekannten Gutsignaturen verglichen. Die jeweils L-exklusiven Oder-Gatter $XOR_{L1}$ und $XOR_{L2}$ stellen die Signaturunterschiede $\Delta S1$ und $\Delta S2$ an den Ausgängen 52 und 53 bereit.

Gemäß der Erfindung kann mithilfe dieser Signaturunterschiede $\Delta S1$ und $\Delta S2$ festgestellt werden, ob bei dem jeweils betrachteten Datenstrom $T_n$ Fehler aufgetreten sind.

Wenn der Datenstrom $T_n$ genau ein fehlerhaftes Datenwort y'(i) aufweist, kann sowohl die Position i des fehlerhaften Datenworts als auch der Fehler e(i) des fehlerhaften Datenworts im Datenstrom direkt bestimmt werden.

Nachfolgend ist die Funktion des ersten Kodierers C1 genau beschrieben.

Der Kodierer C1 kodiert für i=1, ..., n das Datenwort y(i) mit der Datenwortlänge von k Bit in ein kodiertes Datenwort $u^1(i)$, $u^1(i)=Codl(y(i))$ der Wortbreite von K1 Bit. Dabei bezeichnet Cod1 die Kodierungsfunktion des ersten Kodierers C1.

Ist y'(i) die komponentenweise XOR-Summe von zwei k Bit breiten Datenwörtern y(i) und e(i), nämlich

$$\texttt{y'(i)} = \texttt{y(i)} \oplus \texttt{e(i)}$$

dann soll für die Kodierungsfunktion Cod1

$$\texttt{u}^1\texttt{'(i)} = \texttt{Cod1(y'(i))} = \texttt{Cod1(y(i)} \oplus \texttt{e(i))}$$
$$= \texttt{Cod1(y(i))} \oplus \texttt{f}_1\texttt{(e(i))} = \texttt{u}^1\texttt{(i)} \oplus \texttt{f}_1\texttt{(e(i))}$$

gelten, so dass es eine Funktion $f_1^{-1}$ mit

$$f_1^{-1}\texttt{(f}_1\texttt{(e))} = \texttt{e}$$

für alle binären Datenworte e der Wortbreite k, die als Fehler möglich sind, gilt.

Realisiert der Kodierer C1 einen linearen Blockkode mit k Informationsstellen und mit (K1-k) Kontrollstellen, dann gilt

$$\texttt{Cod1(y'(i))} = \texttt{Cod1(y(i)} \oplus \texttt{e(i))}$$
$$= \texttt{Cod1(y(i))} \oplus \texttt{Cod1(e(i))}$$

und es gilt

$$\texttt{f}_1 = \texttt{Cod1.}$$

Lineare Blockkodes sind bspw. in Dokument [1] beschrieben.

Sind z.B. k = 3 und K1 = 5 und gilt

$$C1(y(i)) \quad = C1([y_1(i)), \; y_2(i), \; y_3(i)]^T)$$
$$= [y_1(i), \; y_2(i), \; y_3(i), \; 1, \; 1]^T,$$

so gilt für y' (i) = y(i) $\oplus$ e (i) :

$$Cod1(y'(i)) \quad = Cod1(y(i) \; \oplus \; e(i))$$
$$= Cod1(y(i)) \; \oplus \; f(e(i))$$

mit

$$f_1(e(i)) \quad = f_1([e_1(i), \; e_2(i), \; e_3(i)]^T)$$

$$= [e_1(i), \; e_2(i), \; e_3(i), \; 0, \; 0]$$

und

$$f_1^{-1}([e_1(i), \; e_2(i), \; e_3(i), \; 0, \; 0]^T) = e_1(i), \; e_2(i), \; e_3(i).$$

Nachfolgend ist die Funktion der ersten linearen Automatenschaltung L1 im einzelnen beschrieben.

Bei der nachfolgenden Beschreibung kann die Zustandsmatrix der linearen Automatenschaltungen L1 und L2 eine beliebige Größe annehmen und ist nicht auf n=4 festgelegt, wie zuvor beschrieben. Ein weiterer Unterschied der nachfolgenden Beschreibung liegt darin, dass es sich bei den Eingabewerten der linearen Automatenschaltungen L1 und L2 um kodierte Datenwörter $u^1(1)$, ..., $u^1(n)$ bzw. $u^2(1)$, ..., $u^2(n)$ handelt, die vom ersten Kodierer C1 bzw. vom zweiten Kodierer C2 aus den Datenwörtern y(1), ..., y(n) kodiert worden sind.

Die erste lineare Automatenschaltung L1 ist über dem Körper GF(2) ausgebildet und weist einen K1-dimensionalen Zustandsvektor $z^1(t)$ auf. Dabei gilt K1 $\geq$ k.

Die erste lineare Automatenschaltung L1 ist allgemein durch die Gleichung

$$z^1(t+1) = A \cdot z^1(t) \oplus u^1(t) \tag{I}$$

beschrieben. Dabei sind $z^1(t)$ und $z^1(t+1)$ K1-dimensionale binäre Zustandsvektoren zum diskreten Zeitpunkt t und t+1. $u^1(t)$ ist das zum Zeitpunkt t eingegebene kodierte Datenwort.

A ist eine eindeutig umkehrbare binäre (K1xK1)-Matrix.

Die Addition und die Multiplikation der binären Werte in Gleichung (I) erfolgen modulo 2.

Nach Eingabe des Datenstroms $T_n$ aus den n Datenwörtern y(1), ..., y(n) in den ersten Kodierer C1 und nach Eingabe der kodierten Datenwörter $u^1(1)$, ..., $u^1(n)$ in die erste lineare Automatenschaltung L1 geht die erste lineare Automatenschaltung L1 von einem Anfangszustand $z^1(1)$ in den Zustand $z^1(n+1)$ über. Dabei gilt:

$$z^1(n+1) = A^n z^1(1) \oplus \sum_{j=1}^{n} A^{n-j} u^1(j)$$

Dabei wird

$$z^1(n+1) = S(L1, u^1(1), ..., u1(n))$$

mit $u^1(i) = Cod1(y(i))$ als Signatur der Datenfolge y(1), ..., y(n) der ersten linearen Automatenschaltung L1 bezeichnet .

Der Anfangszustand $z^1(1)$ soll nachfolgend gleich dem K1-dimensionalen Nullvektor 0 sein. Für die Durchführung des erfindungsgemäßen Verfahrens ist es nicht notwendig, dass der Anfangszustand $z^1(1)$ als Nullvektor ausgebildet ist. Diese Annahme wird hier getroffen, um die nachfolgenden Rechnungen zu vereinfachen.

Liegt nun ein Fehler e(i) im i-ten Datenwort des Datenstroms vor, dann wird zum i-ten Zeitpunkt anstatt des richtigen Datenwortes y(i) das fehlerhafte Datenwort

$$y'(i) = y(i) \oplus e(i)$$

in den ersten Kodierer C1 eingegeben. Dabei ist der Fehler e(i) ein k-dimensionaler Binärvektor. Diejenigen Komponenten dieses Binärvektors, die den Wert Eins annehmen, bezeichnen die Positionen der fehlerhaften Bits in dem i-ten Datenwort.

Ist nur das i-te Datenwort fehlerhaft und sind alle anderen Datenwörter korrekt, so gilt mit $z^1(1) = 0$ bei Eingabe des nur im i-ten Datenwort fehlerhaften Datenstroms in den ersten Kodierer C1 mit

$$\begin{aligned}
u^{1'}(i) &= Cod1(y'(i)) \\
&= Cod1(y(i) \oplus e(i)) \\
&= Cod1(u(i)) \oplus f_1(e(i)) \\
&= u^1(i) \oplus f_1(e(i))
\end{aligned}$$

$$\begin{aligned}
z^{1'}(n+1) &= \sum_{j=1}^{n} A^{n-i} u^1(j) \oplus A^{n-1} \cdot f_1(e(i)) &&\text{(II)} \\
&= z^1(n+1) \oplus A^{n-i} f_1(e(i)) &&\text{(III)}
\end{aligned}$$

und damit

$$A^{n-i} \cdot f_1(e(i)) = z^{1'}(n+1) \oplus z^1(n+1)$$

$$= \text{S(L1, u}^1\text{(1), ..., u}^{1'}\text{(i), ..., u}^1\text{(n))}$$

$$\oplus \text{ S(L1, u}^1\text{(1), ...,u}^1\text{(i), ..., u}^1\text{(n))}$$

$$= \Delta S1 \qquad\qquad\qquad\qquad (\text{IV})$$

Für den Fall, dass f(e(i)) = Cod1(e(i)) ist, erhält man

$$\text{A}^{n-i} \text{ Cod1(e(i))} = \Delta S1 \qquad\qquad\qquad\qquad (\text{V})$$

Für den Fall, dass Cod1(y(i)) = y(i), i=1, ..., n gilt, ergibt sich

$$A^{n-i} \cdot e(i) = \Delta S1 \qquad\qquad\qquad\qquad (\text{VI})$$

Nachfolgend ist die Funktion des zweiten Kodierers C2 genau beschrieben.

Der zweite Kodierer C2 kodiert für i=I, ..., n das Datenwort y(i) mit der Datenwortlänge von k Bit in das kodierte Datenwort $u^2$(i), $u^2$(i) = Cod2(y(i)). Das kodierte Datenwort $u^2$(i)hat eine Wortbreite von K2 Bit. Dabei bezeichnet Cod2 die Kodierungsfunktion des zweiten Kodierers C2.

Ist y'(i) die komponentenweise XOR-Summe von zwei k Bit breiten Wörtern y(i) und e(i).

$$\text{y'(i)} = \text{y(i)} \oplus \text{e(i),}$$

dann soll für die Kodierungsfunktion Cod2

$$\text{u}^{2'}\text{(i)} = \text{Cod2(y'(i))}$$

$$= \text{Cod2(y(i)} \oplus \text{e(i))}$$

$$= \text{Cod2(y(i))} \oplus \text{f}_2\text{(e(i))}$$

$$= \text{u}^2\text{(i)} \oplus \text{f}_2\text{(e(i))}$$

gelten, so dass es eine Funktion $f_2^{-1}$ mit $f_2^{-1}$ (f$_2$(e)) = e für alle binären Datenworte e der Wortbreite k, die als Fehler in Betracht kommen können, gibt.

Nachfolgend ist die Funktion der zweiten linearen Automatenschaltung L2 im einzelnen beschrieben.

Die zweite lineare Automatenschaltung L2 ist über dem Körper GF(2) ausgebildet und weist einen K2-dimensionalen Zustandsvektor $z^2$(t) auf. Dabei gilt K2 $\geq$ k.

Die zweite lineare Automatenschaltung L2 ist durch die Gleichung

$$\text{z}^2\text{(t+1)} = B \cdot z^2(t)u^2(t) \qquad\qquad\qquad\qquad (\text{VII})$$

beschrieben, wobei $z^2(t)$ und $z^2(t+1)$ K2-dimensionale binäre Zustandsvektoren zu den diskreten Zeitpunkten t und t+1 sind. $u^2(t)$ ist das zum Zeitpunkt t eingegebene kodierte Datenwort. B mit B ≠ A ist eine eindeutig umkehrbare binäre (K2xK2)-Matrix. Die Addition und Multiplikation in (VII) erfolgt modulo 2.

Nach Eingabe des Datenstroms $T_n$ aus den n Datenwörtern y(1), ..., y(n) in den zweiten Kodierer C2 und nach Eingabe der kodierten Datenwörter $u^2(1)$, ..., $u^2(n)$ in die zweite lineare Automatenschaltung L2 geht die zweite lineare Automatenschaltung L2 aus ihrem Anfangszustand $z^2(1)$ in den Zustand $z^2(n+1)$

$$z^2(n+1) \qquad = B^n z^2(1) \oplus \sum_{j=1}^{n} B^{n-j} u^2(j) \qquad\qquad (VIII)$$

über. Dabei ist

$$z^2(n+1) \quad = S(L2, u^2(1), ..., u^2(n))$$

mit $u^2(i) = Cod2(y(i))$ als die Signatur des Datenstromes y(1), ..., y(n) in der zweiten linearen Automatenschaltung L2 bezeichnet.

Der K1-dimensionale Nullvektor 0 bildet nachfolgend den Anfangszustand $z^2(1)$.

Liegt nun ein Fehler e(i) im i-ten Datenwort des Datenstromes vor, dann wird im i-ten Zeitpunkt anstatt des richtigen Datenwortes y(i) das fehlerhafte Datenwort y'(i) = y(i) ⊕ e(i) in den zweiten Kodierer Cod2 eingegeben.

Ist nur das i-te Datenwort fehlerhaft und sind alle anderen Datenwörter korrekt, so gilt mit $z^2(1)$ - 0, mit

$$u^2{}'(i) \qquad = Cod2(y(i) \oplus e(i))$$

$$= u^2(i) \oplus f_2(e(i)) \quad (analog\ zu\ (III))$$

$$z^2{}'(n+1) \quad = \sum_{i=1}^{n} B^{n-i} u^2(j) + B^{n-i} f_2(e(i))$$

$$= z^2(n+1) \oplus B^{n-i} f_2(e(i)) \qquad\qquad (IX)$$

und mit

$$z^2{}'(n+1) \ \oplus \ z^2(n+1)$$

$$= \ S(L2, u^2(1), ..., u^2{}'(i), ..., u^2(n))$$

$$\oplus \ S(L2, u^2(1), ..., u^2(i), ..., u^2(n))$$

$$= \ \Delta S2$$

folgende Gleichung:

$$\Delta S2 \qquad = \quad B^{n-i} f_2(e(i)) \qquad\qquad\qquad (\text{X})$$

Für den Fall, dass $f_2(e(i)) = \text{Cod}2(e(i))$ ist, gilt anstelle von (X)

$$\Delta S2 \qquad = \quad B^{n-i} \text{Cod}2(e(i)) \qquad\qquad\qquad (\text{XI})$$

Für den Fall, dass $\text{Cod}2(e(i)) = e(i)$ gilt, ergibt sich

$$\Delta S2 \qquad = \quad B^{n-i} \cdot e(i) \qquad\qquad\qquad (\text{XII})$$

Wenn die Ergebnisse der Verarbeitung des Datenstromes in den linearen Automatenschaltungen L1 und L2 kombiniert werden, so erhält man aus den Gleichungen (IV) und (X)

$$e(i) \qquad = \quad f_1^{-1}(A^{i-n}\Delta S1) \qquad\qquad\qquad (\text{XIV})$$

$$e(i) \qquad = \quad f_2^{-1}(B^{i-n}\Delta S2) \qquad\qquad\qquad (\text{XV})$$

woraus sich folgende Gleichung ergibt:

$$f_1^{-1}(A^{i-n}\Delta S2) \qquad = \quad f_2^{-1}(B^{i-n}\Delta S2) \qquad\qquad\qquad (\text{XVI})$$

Mittels der Gleichung (XVI) kann i, $i \in (1,...,n)$, also die Position i des fehlerhaften Datenworts y'(i) berechnet werden.

Der Wert für i aus Gleichung (XVI) kann bspw. iterativ dadurch berechnet werden, indem man für i = 1, 2, ... den Wert der linken und rechten Seite der Gleichung (XVI) solange berechnet, bis beide Seiten übereinstimmen.

Wenn der Wert für i auf diese Weise bestimmt worden ist, dann kann mittels der Gleichung (XIV) auch der Wert für e(i), also die Position des fehlerhaften Datenworts im Datenstrom direkt bestimmt werden.

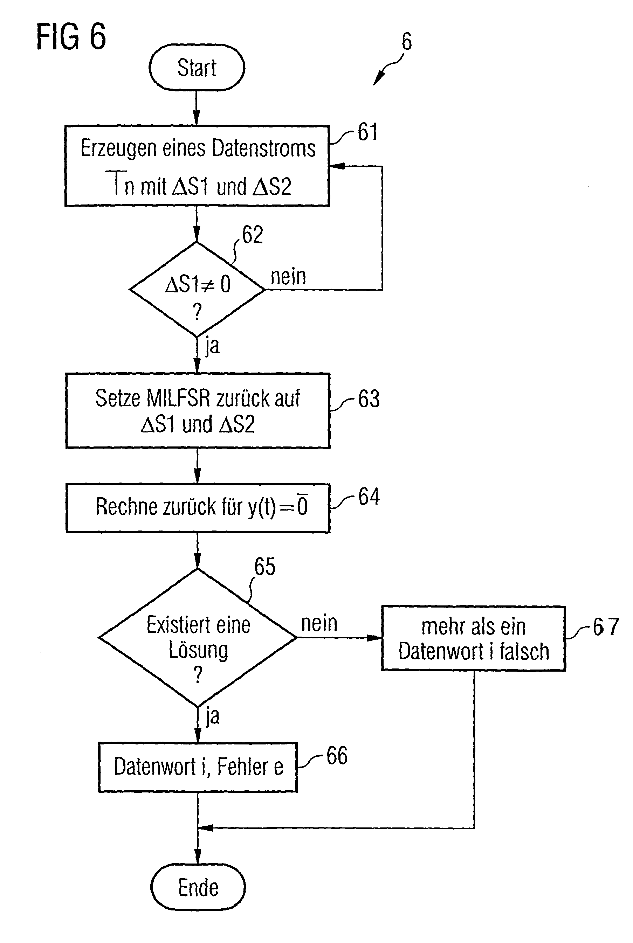

Figur 6 zeigt ein Ablaufdiagramm 6 zur Veranschaulichung des erfindungsgemäßen Verfahrens zum Feststellen eines Fehlers e(i) in einem Datenwort y'(i).

Das erste Ablaufdiagramm 6 sieht insgesamt sieben Verfahrensschritte 61-67 vor, wobei die Verfahrensschritte 62 und 65 als Entscheidungsfelder und die restlichen Verfahrensschritte als Ausführungsfelder ausgebildet sind.

Im ersten Verfahrensschritt 61 werden die Signaturunterschiede $\Delta S1$ und $\Delta S2$ sowie ein Datenstrom $T_n$ erzeugt, wie er bspw. in den Figuren 1 und 2 dargestellt ist. Dieser Datenstrom $T_n$ kann aus einer Abfolge von Messdaten eines DUT gebildet sein.

Dieser Datenstrom $T_n$ wird - wie mit Bezug auf Figur 5 ausführlich beschrieben - über den ersten Kodierer C1 der ersten linearen Automatenschaltung L1 und gleichzeitig dazu über den zweiten Kodierer C1 der zweiten linearen Automatenschaltung L2 zugeführt. Aus den von den linearen Automatenschaltungen L1 und L2 erzeugten Signaturen und aus den bereitgestellten Gutsignaturen bestimmen die exklusiven Oder-Gatter $\text{XOR}_{L1}$ und $\text{XOR}_{L2}$ die Signaturunterschiede $\Delta S1$ und $\Delta S2$ aus der Differenz der Gut- und Schlecht-Signaturen gemäß Gleichung (1) und Gleichung (2) und stellen die Signaturunterschiede $\Delta S1$ und $\Delta S2$ an den Ausgängen 52 und 53 bereit.

Im zweiten Verfahrensschritt 62 wird der am ersten Ausgang 52 anliegende Signaturunterschied $\Delta S1$ mit Null verglichen. Ist der Signaturunterschied $\Delta S1$ gleich Null, bedeutet dies, dass kein Fehler im Datenstrom $T_n$ festgestellt werden konnte. In diesem Fall wird mit der Überprüfung des nächsten Datenstroms $T_n$ fortgefahren. Ist der Signaturunterschied $\Delta S1$ ungleich Null, bedeutet dies, dass ein oder beliebig viele fehlerhafte Datenworte y(1), ..., y(n) fehlerhaft sind. In diesem Fall wird mit dem Verfahrensschritt 63 fortgesetzt.

Im Verfahrensschritt 63 werden die Zustände $z(t=n+1)$ der linearen Automatenschaltungen L1 und L2 jeweils auf die Werte der jeweils anderen Signaturunterschiede $\Delta S1$ und $\Delta S2$ zurück gesetzt.

Im Verfahrensschritt 64 wird für $y(t)=0$ zurückgerechnet, und zwar werden die linearen Automatenschaltungen L1 und L2 in (n-i) Schritten für $y(t)=0$ akkumuliert und die Zustände nach Gleichung (26) auf Identität geprüft. Dieses Zurückrechnen ist dem Fachmann bekannt und braucht hier nicht weiter erläutert zu werden.

Im Verfahrensschritt 65 wird überprüft, ob eine Lösung existiert. Ist dies nicht der Fall, so ist mehr als ein Datenwort y(1), ..., y(n) des Datenstroms $T_n$ fehlerhaft.

Wenn eine Lösung existiert, so werden das Datenwort y'(i) und der Fehler e(i) im Verfahrensschritt 66 berechnet.

Zunächst wird dabei das Datenwort y'(i) aus der Anzahl der durchlaufenen Zyklen der linearen Automatenschaltung L1 und L2 bestimmt.

Danach wird der Fehler e(i) aus der Gleichung (30) berechnet:

$$e(i) = z(t) \quad \text{für} \quad t=i, \quad 1 \leq i \leq N \tag{30}$$

$z(t=i)$ ist der Zustand der beiden linearen Automatenschaltungen L1 und L2 zum Zeitpunkt t=i.

In einem weiteren Ausführungsbeispiel können auch zwei serielle, also aufeinanderfolgende Datenströme $T_n$ überprüft werden.

In diesem Fall wird der linke Ast der Messdatenwortleitung 51 zweimal hintereinander und der rechte Ast der Messdatenwortleitung 51 gar nicht durchlaufen, wobei im zweiten Durchlauf der erste Kodierer C1 durch den zweiten Kodierer C2 ersetzt wird, falls sich der erste Kodierer C1 vom zweiten Kodierer C2 unterscheidet und die erste lineare Automatenschaltung L1 mit der Zustandsmatrix A durch die zweite lineare Automatenschaltung L2 mit der Zustandsmatrix B, B#A ersetzt wird, was technisch bspw. einfach unter Verwendung von Multiplexern erfolgen kann.

Wird das Verfahren auf einem Computersystem realisiert, so ist ganz einfach derjenige Programmteil, der die erste lineare Automatenschaltung L1 realisiert, im zweiten Durchlauf durch denjenigen Programmteil, der die zweite lineare Automatenschaltung L2 realisiert, zu ersetzen. Ebenso ist, falls sich die Kodierer C1 und C2 voneinander unterscheiden, die Funktion Cod1 des ersten Kodierers C1 im ersten Durchlauf durch die Funktion Cod2 des zweiten Kodierers C2 im zweiten Durchlauf zu ersetzen.

In diesem Fall ist S1 die beim ersten Durchlauf errechnete Signatur und S2 die beim zweiten Durchlauf errechnete Signatur. Das Verfahren stimmt im wesentlichen mit dem im vorigen Ausführungsbeispiel beschriebenen Verfahren überein.

Die Ausführung des Verfahrens ist für einen Fachmann anhand der in dieser Patentschrift gegebenen Informationen ohne wieteres möglich.

Folgendes Dokument wurden im Rahmen dieser Patentschrift zitiert:

[1] Rohling H., Einführung in die Informations- und Codierungstheorie, Teubner Verlag, 1995

Um einen Fehler e(i) an der Position i des Datenstroms $T_n$ eindeutig zu erkennen und zu diagnostizieren, ist es überraschenderweise nicht notwendig, dass das Rückkopplungspolynom primitiv oder irreduziebel ist. Es genügt hier tatsächlich, dass die Matrix B invers zur Matrix A ist.

So bestimmt sich der Wert der Position des Fehlers i, der natürlich im Datenstrom von 1 bis n auftreten muss, aus der Gleichung

$$f_1^{-1}(A^{i-n} \Delta S_1) = f_2^{-1}(B^{i-n} \Delta S_2)$$

und mit nun $B = A^{-1}$ zu

$$f_1^{-1}(A^{i-n}\,\Delta S_1)\ =\ f_2^{-1}(A^{n-i}\,\Delta S_2).$$

Und für e(i), die fehlerhaften Bitpositionen im fehlerhaften i-ten Datenwort, ergibt sich

$$e(i)\ =\ f_1^{-1}\ (A^{i-n}\,\Delta S_1).$$

Besitzt die Matrix A eine inverse Matrix $A^{-1}$, so gilt $A^k_e(i) \neq \underline{0}$ für $e(i) \neq \underline{0}$ für jedes k. Damit, und weil für lineare Schiebregister eine lineares Superpositionsprinzip gilt, kann ein einzelner Fehler e(i), der verschiedene Bits an der Position i verfälscht hat, niemals maskiert werden. Dadurch, dass die Signatur darüber hinaus noch in zwei unterschiedlichen Multi-Input Signaturregistern mit zueinander inversen Matizen A und $B = A^{-1}$ bereitgestellt wird, ist es sogar möglich, die Position i und den Wert e(i) exakt zu bestimmen.

Eine Maskierung von Fehlern in einer Signatur, die der Gutsignatur gleich ist, kann nur mit einer verschwindend kleinen Wahrscheinlichkeit vorkommen, wenn mehrere Fehler an mehreren Bitpositionen auftreten, die sich zufällig in ihrer Signatur aufheben. Bei einer einzigen fehlerhaften Position, ist dies, wie ausgeführt, nicht möglich.

Die Wahrscheinlichkeit, dass beim Vorliegen von mehren Fehlern die Gleichung

$$f_1^{-1}(A^{i-n}\,\Delta S_1)\ =\ f_2^{-1}(A^{n-i}\,\Delta S_2)$$

für i mit $1 \leq i \leq n$ eine Lösung hat, ist vernachlässigbar klein und kommt es vor, dass keine Lösung für i gefunden werden kann, bedeutet das, dass kein einzelner Fehler e(i), der nur fehlerhafte Bits an der Position i im Datenstrom aufweist, vorliegt. Die Eigenschaft, dass das Rückführungspolynom primitiv sein soll, ist eine vorteilhafte Ausgestaltung, für die die an sich schon praktisch vernachlässigbar kleine Fehlermaskierungswahrscheinlichkeit für Fehler, die mehrere Positionen im Datenstrom $T_n$ betreffen, ganz besonders klein ist.

**Patentansprüche**

1. Auswerteschaltung zum Feststellen und/oder zum Lokalisieren fehlerhafter Datenworter in einem Datenstrom $T_n$ mit den folgenden Merkmalen:

- eine erste lineare Automatenschaltung (L1) sowie eine parallel geschaltete zweite lineare Automatenschaltung (L2) mit jeweils einer Menge von Zuständen z(t),
- die erste lineare Automatenschaltung (L1) und die zweite lineare Automatenschaltung (L2) weisen eine gemeinsame Eingangsleitung zur Aufnahme eines Datenstroms $T_n$ aus n aufeinanderfolgenden, jeweils k Bit breiten Datenwörtern y(1), ..., y(n) auf,
- die erste lineare Automatenschaltung (L1) ist durch folgende Gleichung beschreibbar,

$$z(t+1) = A\,z(t) \oplus y(t)$$

wobei mit $\oplus$ die komponentenweise Addition modulo 2 bezeichnet ist.
- die zweite lineare Automatenschaltung (L2) ist durch folgende Gleichung beschreibbar,

$$z(t+1) = B\,z(t) \oplus y(t)$$

wobei A und B die Zustandsmatrizen der linearen Automatenschaltungen (L1, L2) darstellen, wobei die Zustandsmatrizen A und B invertierbar sind und wobei die Dimension L der Zustandsvektoren $\geq k$ ist,

- die erste lineare Automatenschaltung (L1) und die zweite lineare Automatenschaltung (L2) sind so ausgebildet, dass eine erste Signatur (S1) bzw. eine zweite Signatur (S2) berechenbar ist,
- L nach der ersten linearen Automatenschaltung (L1) angeordnete erste Verknüpfungsgatter ($XOR_{L1}$) sowie L nach der zweiten linearen Automatenschaltung (L2) angeordnete zweite Verknüpfungsgatter ($XOR_{L2}$),
- die Verknüpfungsgatter ($XOR_{L1}$, $XOR_{L2}$) sind so ausgebildet, dass die jeweils von der linearen Automatenschaltung (L1, L2) berechnete Signatur (S1, S2) mit einer vorgebbaren Gutsignatur vergleichbar und ein Vergleichswert ausgebbar ist.

**2.** Auswerteschaltung nach Anspruch 1,
**dadurch gekennzeichnet, dass**
die Verknüpfungsgatter ($XOR_{L1}$, $XOR_{L2}$) als exklusive Oder-Gatter vorliegen, deren erste Eingänge jeweils mit den Ausgängen der zugehörigen linearen Automatenschaltung (L1, L2) verbunden sind und an deren zweiten Eingängen Gutsignaturen anlegbar sind.

**3.** Auswerteschaltung nach Anspruch 1 oder 2,
**dadurch gekennzeichnet, dass**
vor der ersten linearen Automatenschaltung (L1) ein erster Kodierer (C1) angeordnet ist, der das Datenwort y(i) mit der Datenwortlänge von k Bit in ein kodiertes Datenwort $u^1(i)$, $u^1(i)=Codl(y(i))$ der Wortbreite von K1 Bit kodiert für i=1, ..., n, und wobei Cod1 die Kodierungsfunktion des ersten Kodierers (C1) darstellt.

**4.** Auswerteschaltung nach Anspruch 3,
**dadurch gekennzeichnet, dass**
für die Kodierungsfunktion des ersten Kodierers (C1) folgendes gilt:

$$\mathtt{Cod1(y'(i))} \quad = \mathtt{u^1(i)} \oplus \mathtt{f_1(e(i)),}$$

oder

$$\mathtt{Cod1(y'(i))} = \mathtt{Cod1(y(i)} \oplus \mathtt{e(i))} = \mathtt{Cod1(y(i)} \oplus \mathtt{f_1(e(i))}$$

wobei für y'(i) = y(i) $\oplus$ e(i) eine Funktion $f_1$ mit $f_1(0) = 0$ existiert und wobei eine Funktion $f_1^{-1}$ mit

$$f_1^{-1}\mathtt{(f_1(e))} = \mathtt{e}$$

für alle binären Datenworte e der Wortbreite k, die als Fehler eines Datenworts vorkommen können, existiert, wobei e ein fehlerhaftes Datenwort des Datenstroms $T_n$ bezeichnet.

**5.** Auswerteschaltung nach einem der Ansprüche 1 bis 4,
**dadurch gekennzeichnet, dass**
vor der zweiten linearen Automatenschaltung (L2) ein zweiter Kodierer (C2) angeordnet ist, der das Datenwort y(i) mit der Datenwortlänge von k Bit in ein kodiertes Datenwort $u^2(i)$, $u^2(i)$ =Cod2 (y(i)) der Wortbreite von K2 Bit kodiert für i=1, ..., n, und wobei Cod2 die Kodierungsfunktion des zweiten Kodierers (C2) darstellt.

**6.** Auswerteschaltung nach Anspruch 5,
**dadurch gekennzeichnet, dass**
für die Kodierungsfunktion des zweiten Kodierers (C2) folgendes gilt:

$$\texttt{Cod2(y'(i))} \;=\; \texttt{u}^2\texttt{(i)} \;\oplus\; \texttt{f}_2\texttt{(e(i))}$$

oder

$$\texttt{Cod2(y'(i))} \;=\; \texttt{Cod2(y(i)} \;\oplus\; \texttt{e(i))}$$

$$\;=\; \texttt{Cod2(y(i))} \;\oplus\; \texttt{f}_2\texttt{(e(i))}$$

wobei eine Funktion $f_2^{-1}$ mit

$$f_2^{-1}\,\texttt{(f}_2\texttt{(e))} \;=\; \texttt{e}$$

für alle binären Datenworte e der Wortbreite k, die als Fehler eines Datenworts vorkommen können, existiert, wobei e ein fehlerhaftes Datenwort des Datenstroms $T_n$ bezeichnet.

**7.** Auswerteschaltung nach einem der Ansprüche 3 bis 6,
**dadurch gekennzeichnet, dass**
die Wortbreite K1 der von dem ersten Kodierer (C1) kodierten Datenwörter $u^1(i)$ gleich der Wortbreite K2 der von dem zweiten Kodierer (C2) kodierten Datenwörter $u^2(i)$ ist.

**8.** Auswerteschaltung nach einem der Ansprüche 3 bis 7,
**dadurch gekennzeichnet, dass**
der erste Kodierer (C1) hinsichtlich seines Aufbaus und seiner Funktion mit dem zweiten Kodierer (C2) übereinstimmt .

**9.** Auswerteschaltung nach einem der Ansprüche 3 bis 8,
**dadurch gekennzeichnet, dass**
die Wortbreite K1 der von dem ersten Kodierer (C1) kodierten Datenwörter $u^1(i)$ und die Wortbreite K2 der von dem zweiten Kodierer (C2) kodierten Datenwörter $u^2(i)$ jeweils gleich der Wortbreite k der Datenwörter y(1), ..., y(n) des Datenstroms $T_n$ ist.

**10.** Auswerteschaltung nach einem der Ansprüche 3 bis 9,
**dadurch gekennzeichnet, dass**
die Kodierungsfunktionen Cod1 und Cod2 des ersten Kodierers und des zweiten Kodierers (C2) wie folgt ausgebildet sind:

$$\texttt{Cod1(y}_1\texttt{(i), y}_2\texttt{(i), ..., y}_k\texttt{(i))}$$

$$\;=\; \texttt{P1(y}_1\texttt{(i), y}_2\texttt{(i), ..., y}_k\texttt{(i), 0, ..., 0)}$$

$$\texttt{Cod2(y}_1\texttt{(i), y}_2\texttt{(i), ..., y}_k\texttt{(i))}$$

$$\;=\; \texttt{P2(y}_1\texttt{(i), y}_2\texttt{(i), ..., y}_k\texttt{(i), 0, ..., 0)}$$

für i, 1, ..., n

wobei die Anzahl der am Ende von P1($y_1$(i), $y_2$(i), ..., $y_k$(i), 0, ...,0) befindlichen Nullen gleich (K1-k) ist, wobei die Anzahl der am Ende von P2($y_1$(i), $y_2$(i), ..., $y_k$(i), 0, ...,0) gleich (K2-k) ist und wobei P1 eine beliebige Permutation der K1 Komponenten von ($y_1$(i), $y_2$(1), ..., $y_k$(i), 0, ...,0) und P2 eine beliebige Permutation der K2 Komponenten von ($y_1$(i), $y_2$(i), ..., $y_k$(i), 0, ... , 0) darstellen.

**11.** Auswerteschaltung nach einem der Ansprüche 3 bis 9,
**dadurch gekennzeichnet, dass**
die Kodierungsfunktionen Cod1 und Cod2 des ersten Kodierers und des zweiten Kodierers (C2) wie folgt ausgebildet sind:

$$\text{Cod1}(y_1(i), y_2(i), \ldots, y_k(i))$$
$$= \text{P1}(y_1(i), y_2(i), \ldots, y_k(i), b_1^1 \ldots, b_{K1-k}^1)$$

$$\text{Cod2}(y_1(i), y_2(i), \ldots, y_k(i))$$
$$= \text{P2}(y_1(i), y_2(i), \ldots, y_k(i), b_1^2 \ldots, b_{K2-k}^2)$$

mit $b_1^1, \ldots, b_{K1-k}^1, b_1^2, \ldots, b_{K2-k}^2 \in \{0,1\}$ und wobei P1 und P2 beliebige Permutationen darstellen.

**12.** Auswerteschaltung nach einem der Ansprüche 3 bis 11,
**dadurch gekennzeichnet, dass**
die Kodierungsfunktion Cod1 des ersten Kodierers (C1) so ausgebildet ist, dass sie einen linearen Blockkode, $f_1$=Cod1, realisiert.

**13.** Auswerteschaltung nach einem der Ansprüche 3 bis 9 oder nach Anspruch 12,
**dadurch gekennzeichnet, dass**
die Kodierungsfunktion Cod2 des zweiten Kodierers (C2) so ausgebildet ist, dass sie einen linearen Blockkode, $f_2$=Cod2, realisiert.

**14.** Auswerteschaltung nach einem der Ansprüche 1 bis 13,
**dadurch gekennzeichnet, dass**
die Zustandsmatrix A der ersten linearen Automatenschaltung (L1) und die Zustandsmatrix B der zweiten linearen Automatenschaltung (L2) wie folgt miteinander in Beziehung stehen:

$$B = A^n$$

mit $n \neq 1$.

**15.** Auswerteschaltung nach einem der Ansprüche 1 bis 14,
**dadurch gekennzeichnet, dass**
die Zustandsmatrix B der zweiten linearen Automatenschaltung (L2) gleich der invertierten Zustandsmatrix $A^{-1}$ der ersten linearen Automatenschaltung (L1) ist

**16.** Auswerteschaltung nach einem der Ansprüche 1 bis 15,
**dadurch gekennzeichnet, dass**
die erste lineare Automatenschaltung (L1) als linear rückgekoppeltes Schieberegister und die zweite lineare Automatenschaltung (L2) als inverses linear rückgekoppeltes Schieberegister ausgebildet sind, wobei beide lineare Automatenschaltungen (L1, L2) eine parallele Eingabe aufweisen.

**17.** Auswerteschaltung nach einem der Ansprüche 1 bis 16,
**dadurch gekennzeichnet, dass**
die erste lineare Automatenschaltung (L1) als linear rückgekoppeltes, K1-dimensionales Multi-Input-Schieberegister und/oder die zweite lineare Automatenschaltung (L2) als linear rückgekoppeltes, K2-dimensionales Multi-Input-Schieberegister ausgebildet sind.

**18.** Auswerteschaltung nach Anspruch 17,
**dadurch gekennzeichnet, dass**
das/die Multi-Input-Schieberegister (L1, L2) ein primitives Rückkopplungspolynom maximaler Länge aufweist/aufweisen.

**19.** Verfahren zum Feststellen und/oder zum Lokalisieren von fehlerhaften Datenworten in einem Datenstrom $T_n$, wobei das Verfahren die folgenden Verfahrensschritte aufweist:

a) Eingeben von Datenwörtern y(1), ..., y(i-1), y'(i), y(i+1), ..., y(n) eines Datenstroms $T_n$ in einen ersten Kodierer (C1),
b) Kodieren der Datenwörter y(1), ..., y(n) in kodierte Datenwörter $u^1(1)$, ..., $u^1(n)$ der Wortbreite K1 mit K1≥k mittels der Kodierfunktion Cod1 des ersten Kodierers (C1),
c) Eingeben der kodierten Datenwörter $u^1(1)$, ..., $u^1(i-1)$, $u^{1'}(i)$ oder $u^1(i)$, $u^1(i)$, ..., $u^1(n)$ in die Eingänge einer ersten linearen Automatenschaltung (L1), die durch die Automatengleichung

$$z^1(t+1) = A \cdot z^1(t) + u^1(t)$$

beschrieben ist, wobei $z^1$ einen Kl-dimensionaler Zustandsvektor und A eine KlxKl-Zustandsmatrix darstellen, und wobei die Zustandsmatrix A invertierbar ist,
d) Verarbeiten der kodierten Datenwörter $u^1(1)$, ..., $u^1(i-1)$, $u^{1'}(i)$ oder $u^1(i)$, $u^1(i)$, ..., $u^1(n)$ durch die erste lineare Automatenschaltung (L1), wobei die erste lineare Automatenschaltung (L1)

- in den Zustand $z^1(n+1) = S_1(L1, y(1), ..., y(i-1), y(i), y(i+1), ..., y(n))$ übergeht, wenn bei den kodierten Datenwörtern $u^1(1)$, ..., $u^1(i-1)$, $u^1(i)$, $u^1(i+1)$, ..., $u^1(n)$ kein Fehler feststellbar ist, $-Z^{1'}(n+1) = S_1(L1, y(1) ..., y(i-1), y'(i), y(i+1), ..., y(n))$ übergeht, wenn wenigstens bei der i-ten Position der kodierten Datenwörter $u^1(1)$, ..., $u^1(i-1)$, $u^{1'}(i)$, ..., $u^1(n)$ ein Fehler vorliegt,

wobei die Signatur eines fehlerfreien Datenstroms $T_n$ mit S(L1, y(1), ..., y(i-1), y(i), y(i+1), ..., y(n)) und die Signatur eines fehlerhaften Datenstroms $T_n$ mit S(L1, y(1), ..., y(i-1), y'(i), y(i+1), ..., y(n)) bezeichnet sind.
e) Überprüfen der bestimmten Signatur des Datenstroms $T_n$ und Fortfahren mit Verfahrenschritt a) für weitere Datenströme $T_n$, falls es sich bei der bestimmten Signatur des Datenstroms $T_n$ um die Signatur eines fehlerfreien Datenstroms $T_n$ handelt,
f) Eingeben der Datenwörter y(1), ..., y(i-1), y'(i), ..., y(n) des Datenstromes $T_n$ in einem zweiten Kodierer (C2),
g) Kodieren der Datenwörter y(1), ..., y(i-1), y'(i), y(i+1), ..., y(n) in kodierte Datenwörter $u^2(1)$, ..., $u^2(i-1)$, $u^{2'}(i)$ oder $u^2(i)$, $u^2(i)$, ..., $u^2(n)$ der Wortbreite K2 mit K2≥k mittels der Kodierfunktion Cod2 des zweiten Kodierers (C2),
h) Eingeben der kodierten Datenwörter $u^2(1)$, ..., $u^2(i-1)$, $u^{2'}(i)$ oder $u^2(i)$, $u^2(i)$ ..., $u^2(n)$ in die Eingänge einer zweiten linearen Automatenschaltung (L2), die durch die Automatengleichung

$$z^2(t+1) = B \cdot z^2(t) \oplus u^2(t)$$

beschrieben ist, wobei $z^2$ einen K2-dimensionalem Zustandsvektor und B eine K2xK2-Zustandsmatrix mit $B \neq A$ darstellen, und wobei die Zustandsmatrix B invertierbar ist,

i) Verarbeiten der kodierten Datenwörter u2(1), ..., u2(i-1), u2'(i) oder u2(i), u2(i), ..., u2(n) durch die zweite lineare Automatenschaltung (L2), wobei die zweite lineare Automatenschaltung (L2)

- in den Zustand z2(n+1)= S2(L2, y(1), ..., y(i-1), y(i), y(i+1), ..., y(n)) übergeht, wenn bei den Datenwörtern u2(1), ..., u2(i-1), u2-(i), u2(i), ..., u2(n) kein Fehler feststellbar ist,
- z2'(n+1)= S2(L2, y(1), ..., y(i-1), y(i), y'(i), y(i+1), ..., y(n)) übergeht, wenn wenigstens bei der i-ten Position der kodierten Datenwörter u2(1), ..., u2(i-1), u2'(i), u2(i) , ..., u2(n) ein Fehler vorliegt,

wobei die Signatur eines fehlerfreien Datenstroms $T_n$ mit S(L2, y(1), ..., y(i-1), y(i), y(i+1), ..., y(n)) und die Signatur eines fehlerhaften Datenstroms $T_n$ mit S(L2, y(1), ..., y(i-1), y'(i), ..., y(n)) bezeichnet sind.
j) Bestimmen der Signaturdifferenzen AS1 und ΔS2 durch exklusive Oder-Verknüpfungen der in Verfahrensschritt d) bzw. i) bestimmten Signaturen S1 und S2 mit ermittelten Gutsignaturen, jeweils nach folgenden Vorschriften:

$$\Delta S1= \ S(L1, \ y(1), \ ..., \ y(i-1), \ y(i), \ y(i+1), \ ..., \ y(n)) \oplus S(L1, \ y(1), \ ..., \ y(i-1), \ y'(i), \ y(i+1), \ ..., \ y(n))$$

$$\Delta S2= \ S(L2, \ y(1), \ ..., \ y(i-1), \ y(i), \ y(i+1), \ ..., \ y(n)) \oplus S(L2, \ y(1), \ ..., \ y(i-1), \ y'(i), \ y(i+1), \ ..., \ y(n))$$

k) Bestimmen einer eindeutigen Lösung für die Position i des fehlerhaften Bits im fehlerhaften Datenwort durch Lösen der Gleichung

$$f_1^{-1}(A^{i-n}\Delta S1) = f_2^{-1}(B^{i-n}\Delta S2)$$

falls sich keine eindeutige Lösung für $1 \le i \le n$ ergibt, Ausgeben einer Mitteilung durch ein Ausgabemedium, dass in dem betrachteten Datenstroms $T_n$ zwei oder mehr Fehler vorliegen,
l) Bestimmen einer eindeutigen Lösung für den Zähler e(i) des fehlerhaften Datenworts y'(i) im Datenstrom $T_n$ durch Lösen der Gleichung

$$e(i) = f_1^{-1}(A^{i-n} \cdot \Delta S1)$$

m) Ausgeben der Position i des fehlerhaften Bits im fehlerhaften Datenwort sowie des Fehlers e(i) des fehlerhaften Datenworts y'(i) im Datenstroms $T_n$ durch ein Ausgabemedium.

**20.** Verfahren nach Anspruch 19,
**dadurch gekennzeichnet, dass**
die Verfahrensschritte mit einer Auswerteschaltung gemäß einem der Ansprüche 1 bis 18 durchgeführt werden.

**21.** Auswerteschaltung nach einem der Ansprüche 1 bis 18,
**dadurch gekennzeichnet, dass**
die Auswerteschaltung auf einem integrierten Schaltkreis monolithisch integriert ist.

**22.** Loadboard zur Aufnahme wenigstens einer Nadelkarte zum Testen von integrierten Schaltkreisen und/oder mit wenigstens einem Testsockel zum Testen von integrierten Schaltkreisen und/oder zum Anschluss eines Handlers an einen Tester von integrierten Schaltkreisen, wobei das Loadboard eine Auswerteschaltung nach einem der Ansprüche 1 bis 18 aufweist.

23. Nadelkarte zum Testen von integrierten Schaltungen, bei der eine Auswerteschaltung nach einem der Ansprüche 1 bis 18 integriert ist.

24. Tester zum Testen von integrierten Schaltkreisen mit den folgenden Merkmalen:

- der Tester verfügt über mehrere Instrumente zum Erzeugen von Signalen oder Datenströmen und über mehrere Mess-Sensoren, insbesondere für Ströme und Spannungen,
- der Tester weist ein Loadboard auf, das zur Aufnahme wenigstens einer Nadelkarte zum Testen von integrierten Schaltkreisen und/oder zum Anschluss eines Handlers an einen Tester von integrierten Schaltkreisen vorgesehen ist und/oder das mit wenigstens einem Testsockel zum Testen von integrierten Schaltkreisen ausgestattet ist,
- der Tester weist eine Auswerteschaltung nach einem der Ansprüche 1 bis 18 auf.

25. Computerprogramm zum Ausführen eines Verfahrens zum Feststellen und/oder zum Lokalisieren von fehlerhaften Datenworten in einem Datenstrom $T_n$, das so ausgebildet ist, daß wenigstens die Verfahrensschritte a) sowie k), l) und m) gemäß Anspruch 19 oder 20 ausführbar sind.

26. Computerprogramm nach Anspruch 25, das auf einem Speichermedium, insbesondere in einem Computerspeicher oder in einem Direktzugriffsspeicher enthalten ist.

27. Computerprogramm nach Anspruch 25, das auf einem elektrischen Trägersignal übertragen wird.

28. Datenträger mit einem Computerprogramm nach Anspruch 25.

29. Verfahren, bei dem ein Computerprogramm nach Anspruch 24 aus einem elektronischen Datennetz wie bspw. aus dem Internet auf einen an das Datennetz angeschlossenen Computer heruntergeladen wird.

**Claims**

1. Evaluation circuit for detecting and/or locating faulty data words in a data stream $T_n$ comprising the following features:

- a first linear automaton circuit (L1) and also a second linear automaton circuit (L2) connected in parallel, each having a set of states z(t),
- the first linear automaton circuit (L1) and the second linear automaton circuit (L2) have a common input line for receiving a data stream $T_n$ comprising n successive data words y(1), ..., y(n) each having a width of k bits,
- the first linear automaton circuit (L1) can be described by the following equation

$$z(t+1) = Az(t) \oplus y(t)$$

where $\oplus$ designates componentwise addition modulo 2,
- the second linear automaton circuit (L2) can be described by the following equation

$$z(t+1) = Bz(t) \oplus y(t)$$

where A and B represent the state matrices of the linear automaton circuits (L1, L2), where the state matrices A and B can be inverted, and where the dimension L of the state vectors is $\geq$ k,
- the first linear automaton circuit (L1) and the second linear automaton circuit (L2) are designed such that a first signature (S1) and a second signature (S2), respectively, can be calculated,
- L first logic combination gates ($XOR_{L1}$) arranged downstream of the first linear automaton circuit (L1) and also L second logic combination gates ($XOR_{L2}$) arranged downstream of the second linear automaton circuit (L2),
- the logic combination gates ($XOR_{L1}$, $XOR_{L2}$) are designed such that the signature (S1, S2) respectively calculated by the linear automaton circuit (L1, L2) can be compared with a predeterminable good signature and a comparison value can be output.

2. Evaluation circuit according to claim 1,
**characterized in that**
the logic combination gates ($XOR_{L1}$, $XOR_{L2}$) are present as exclusive-OR gates whose first inputs are respectively connected to the outputs of the associated linear automaton circuit (L1, L2) and to whose second inputs good signatures can be applied.

3. Evaluation circuit according to claim 1 or 2,
**characterized in that**
arranged upstream of the first linear automaton circuit (L1) is a first coder (C1), which codes the data word y(i) having the data word length of k bits into a coded data word $u^1$ (i), $u^1$ (i) =Cod1 (y (i)) having the word width of K1 bits, for i=2, ..., n, and where Cod1 represents the coding function of the first coder (C1).

4. Evaluation circuit according to claim 3,
**characterized in that**
the following holds true for the coding function of the first coder (C1):

$$\text{Cod1}(y'(i)) = u^1(i) \oplus f_1(e(i)),$$

or

$$\text{Cod1}(y'(i)) = \text{Cod1}(y(i) \oplus e(i)) = \text{Cod1}(y(i) \oplus f_1(e(i)))$$

where a function $f_1$ by $f_1(0) = 0$ exists for y'(i) = y(i) $\oplus$ e(i), and where a function $f_1^{-1}$ where

$$f_1^{-1}(f_1(e)) = e$$

exists for all binary data words e having the word width k which may occur as errors of a data word, where e denotes a faulty data word of the data stream $T_n$.

5. Evaluation circuit according to one of claims 1 to 4,
**characterized in that**
arranged upstream of the second linear automaton circuit (L2) is a second coder (C2), which codes the data word y(i) having the data word length of k bits into a coded data word $u^2$(i), $u^2$(i)=Cod2 (y(i)) having the word width of K2 bits, for i=1, ..., n, and where Cod2 represents the coding function of the second coder (C2).

6. Evaluation circuit according to claim 5,
**characterized in that**
the following holds true for the coding function of the second coder (C2):

$$\text{Cod2}(y'(i)) = u^2(i) \oplus f_2(e(i)),$$

or

$$Cod2(y'(i)) = Cod2(y(i) \oplus e(i))$$
$$= Cod2(y(i)) \oplus f_2(e(i))$$

where a function $f_2^{-1}$ where

$$f_2^{-1}(f_2(e)) = e$$

exists for all binary data words e having the word width k which may occur as errors of a data word, where e denotes a faulty data word of the data stream $T_n$.

7. Evaluation circuit according to one of claims 3 to 6,
**characterized in that**
the word width K1 of the data words $u^1(i)$ coded by the first coder (C1) is equal to the word width K2 of the data words $u^2(i)$ coded by the second coder (C2).

8. Evaluation circuit according to one of claims 3 to 7,
**characterized in that**
the first coder (C1) matches the second coder (C2) with regard to its construction and its function.

9. Evaluation circuit according to one of claims 3 to 8,
**characterized in that**
the word width K1 of the data words $u^1(i)$ coded by the first coder (C1) and the word width K2 of the data words $u^2(i)$ coded by the second coder (C2) are in each case equal to the word width k of the data words y (1) , ..., y(n) of the data stream $T_n$.

10. Evaluation circuit according to one of claims 3 to 9,
**characterized in that**
the coding functions Cod1 and Cod2 of the first coder and of the second coder (C2) are designed as follows:

$$Cod1(y_1(i), y_2(i), ..., y_k(i))$$
$$= P1(y_1(i), y_2(i), ..., y_k(i), 0, ..., 0)$$

$$Cod2(y_1(i), y_2(i), ..., y_k(i))$$
$$= P2(y_1(i), y_2(i), ..., y_k(i), 0, ..., 0)$$

for i, 1, ..., n
where the number of zeros situated at the end of $P1(y_1(i), y_2(i), ..., y_k(i), 0, ..., 0)$ is equal to (K1-k), where the number at the end of $P2(y_1(i), y_2(i), ..., y_k(i), 0, ..., 0)$ is equal to (K2-k), and where P1 represents an arbitrary permutation of the K1 components of $(y_1(i), y_2(i), ..., y_k(i), 0, ...,0)$ and P2 represents an arbitrary permutation of the K2 components of $(y_1(i), y_2(i), ..., y_k(i), 0, ...,0)$.

**11.** Evaluation circuit according to one of claims 3 to 9,
**characterized in that**
the coding functions Cod1 and Cod2 of the first coder and of the second coder (C2) are designed as follows:

$$\mathrm{Cod1}(y_1(i),\ y_2(i),\ \ldots,\ y_k(i))$$
$$= \mathrm{P1}(y_1(i),\ y_2(i),\ \ldots,\ y_k(i),\ b_1^1 \ldots,\ b_{K1\ k}^1)$$

$$\mathrm{Cod2}(y_1(i),\ y_2(i),\ \ldots,\ y_k(i))$$
$$= \mathrm{P2}(y_1(i),\ y_2(i),\ \ldots,\ y_k(i),\ b_1^2 \ldots,\ b_{K2\ k}^2)$$

where $b_1^1, \ldots, b_{K1\text{-}k}^1, b_1^2, \ldots, b_{K2\text{-}k}^2 \in \{0.1\}$, and where P1 and P2 represent arbitrary permutations.

**12.** Evaluation circuit according to one of claims 3 to 11,
**characterized in that**
the coding function Cod1 of the first coder (C1) is designed such that it realizes a linear block code, $f_1$=Cod1.

**13.** Evaluation circuit according to one of claims 3 to 9 or according to claim 12,
**characterized in that**
the coding function Cod2 of the second coder (C2) is designed such that it realizes a linear block code, $f_2$=Cod2 .

**14.** Evaluation circuit according to one of claims 1 to 13,
**characterized in that**
the state matrix A of the first linear automaton circuit (L1) and the state matrix B of the second linear automaton circuit (L2) are related to one another as follows:

$$B = A^n$$

where n#1.

**15.** Evaluation circuit according to one of claims 1 to 14,
**characterized in that**
the state matrix B of the second linear automaton circuit (L2) is equal to the inverted state matrix $A^{-1}$ of the first linear automaton circuit (L1).

**16.** Evaluation circuit according to one of claims 1 to 15,
**characterized in that**
the first linear automaton circuit (L1) is designed as a linear feedback shift register and the second linear automaton circuit (L2) is designed as an inverse linear feedback shift register, both linear automaton circuits (L1, L2) having a parallel input.

**17.** Evaluation circuit according to one of claims 1 to 16,
**characterized in that**
the first linear automaton circuit (L1) is designed as a linear feedback, K1-dimensional multi-input shift register and/or the second linear automaton circuit (L2) is designed as a linear feedback, K2-dimensional multi-input shift register.

18. Evaluation circuit according to claim 17,
**characterized in that**
the multi-input shift register/registers (L1, L2) has/have a primitive feedback polynomial of maximum length.

19. Method for detecting and/or locating faulty data words in a data stream $T_n$, the method having the following method steps of:

a) inputting data words y(1), ..., y(i-1), y'(i), y(i+1), ..., y(n) of a data stream $T_n$ into a first coder (C1),
b) coding the data words y(1), ..., y(n) into coded data words $u^1(1)$, ..., $u^1(n)$ having the word width K1 where K1$\geq$k by means of the coding function Cod1 of the first coder (C1),
c) inputting the coded data words $u^1(1)$ ..., $u^1(i-1)$, $u^{1\prime}(i)$ or $u^1(i)$, $u^1(i)$, ..., $u^1(n)$ into the inputs of a first linear automaton circuit (L1), which is described by the automaton equation

$$z^1(t+1) = A \cdot z^1(t) + u^1(t)$$

where $z^1$ represents a K1-dimensional state vector and A represents a K1xK1 state matrix, and where the state matrix A can be inverted,
d) processing the coded data words $u^1(1)$, ..., $u^1(i-1)$, $u^{1\prime}(i)$ or $u^1(i)$, $u^1(i)$, ..., $u^1(n)$ by means of the first linear automaton circuit (L1), the first linear automaton circuit (L1)

- undergoing transition to the state $z^1(n+1)=S_1$(L1, y(1), ..., y(i-1), y(i), y(i+1), ..., y(n)) if no error can be detected in the case of the coded data words $u^1(1)$, ..., $u^1(i-1)$, $u^1(i)$, $u^1(i+1)$, ..., $u^1(n)$,
- undergoing transition $z^{1\prime}(n+1)=S_1$(L1, y(1), ..., y(i-1), y'(i), y(i+1), ..., y(n)) if an error is present at least in the case of the i-th position of the coded data words $u^1(1)$, ..., $u^1(i-1)$, $u^{1\prime}(i)$, ..., $u^1(n)$,

the signature of an error-free data stream $T_n$ being designated by S (L1, y(1), ..., y(i-1), y(i), y(i+1), ..., y(n)) and the signature of a faulty data stream $T_n$ being designated by S(L1, y(1), ..., y(i-1), y'(i), y(i+1), ..., y(n)),
e) checking the determined signature of the data stream $T_n$ and continuing with method step a) for further data streams $T_n$ if the determined signature of the data stream $T_n$ is the signature of an error-free data stream $T_n$,
f) inputting the data words y(1), ..., y(i-1), y'(i), ..., y(n) of the data stream $T_n$ in a second coder (C2) ,
g) coding the data words y(1), ..., y(i-1), y'(i), y(i+1), ..., y(n) to coded data words $u^2(1)$, ..., $u^2(i-1)$, $u^{2\prime}(i)$ or $u^2(i)$, $u^2(i)$, ..., $u^2(n)$ having the word width K2 where K2$\geq$k by means of the coding function Cod2 of the second coder (C2),
h) inputting the coded data words $u^2(1)$, ..., $u^2(i-1)$, $u^{2\prime}(i)$ or $u^2(i)$, $u^2(i)$, ..., $u^2(n)$ into the inputs of a second linear automaton circuit (L2), which is described by the automaton equation

$$z^2(t+1) = B \cdot z^2(t) \oplus u^2(t)$$

where $z^2$ represents a K2-dimensional state vector and B represents a K2xK2 state matrix where *B$\neq$A*, and where the state matrix B can be inverted,
i) processing the coded data words $u^2(1)$, ..., $u^2(i-1)$, $u^{2\prime}(i)$ or $u^2(i)$, $u^2(i)$, ..., $u^2(n)$ by means of the second linear automaton circuit (L2), the second linear automaton circuit (L2)

- undergoing transition to the state $z^2(n+1)=S_2$(L2, y(1), ..., y(i-1), y(i), y(i+1), ..., y(n)) if no error can be detected in the case of the data words $u^2(1)$, ..., $u^2(i-1)$, $u^2(i)$, $u^2(i)$, ..., $u^2(n)$,
- undergoing transition $z^{2\prime}(n+1)=S_2$(L2, y(1), ..., y(i-1), y(i), y'(i), y(i+1), ..., y(n)) if an error is present at least in the case of the i-th position of the coded data words $u^2(1)$, ..., $u^2(i-1)$, $u^{2\prime}(i)$, $u^2(i)$, ..., $u^2(n)$,

the signature of an error-free data stream $T_n$ being designated by S(L2, y(1), ..., y(i-1), y(i), y(i+1), ..., y(n)) and the signature of a faulty data stream $T_n$ being designated by S(L2, y(1), ..., y(i-1), y'(i), ..., y(n)),
j) determining the signature differences $\Delta$S1 and $\Delta$S2 by means of exclusive-OR logic combinations of the signatures S1 and S2 determined in method step d) and i), respectively, with ascertained good signatures, in each case according to the following specifications:

$$\Delta S1 = S(L1, y(1), \ldots, y(i-1), y(i), y(i+1), \ldots, y(n))$$
$$\oplus \quad S(L1, y(1), \ldots, y(i-1), y'(i), y(i+1)\ldots, y(n))$$

$$\Delta S2 = S(L2, y(1), \ldots, y(i-1), y(i), y(i+1), \ldots, y(n))$$
$$\oplus \quad S(L2, y(1), \ldots, y(i-1), y'(i), y(i+1), \ldots, y(n))$$

k) determining a unique solution for the position i of the faulty bit in the faulty data word by solving the equation

$$f_1^{-1}(A^{i-n}\Delta S1) = f_2^{-1}(B^{i-n}\Delta S2)$$

and if no unique solution results for $1 \leq i \leq n$, outputting a notification by means of an output medium that two or more errors are present in the data stream $T_n$ under consideration,
l) determining a unique solution for the counter e(i) of the faulty data word y'(i) in the data stream $T_n$ by solving the equation

$$e(i) = f_1^{-1}(A^{i-n} \cdot \Delta S1)$$

m) outputting the position i of the faulty bit in the faulty data word and also the error e(i) of the faulty data word y'(i) in the data stream $T_n$ by means of an output medium.

**20.** Method according to claim 19,
**characterized in that**
the method steps are carried out by means of an evaluation circuit according to one of claims 1 to 18.

**21.** Evaluation circuit according to one of claims 1 to 18,
**characterized in that**
the evaluation circuit is monolithically integrated on an integrated circuit.

**22.** Loadboard for receiving at least one needle card for testing integrated circuits and/or having at least one test receptacle for testing integrated circuits and/or for connecting a handler to a tester of integrated circuits, the loadboard having an evaluation circuit according to one of claims 1 to 18.

**23.** Needle card for testing integrated circuits, in which an evaluation circuit according to one of claims 1 to 18 is integrated.

**24.** Tester for testing integrated circuits having the following features:

- the tester is provided with a plurality of instruments for generating signals or data streams and with a plurality of measuring sensors, in particular for currents and voltages,
- the tester has a loadboard which is provided for receiving at least one needle card for testing integrated circuits and/or for connecting a handler to a tester of integrated circuits and/or which is equipped with at least one test receptacle for testing integrated circuits, and
- the tester has an evaluation circuit according to one of claims 1 to 18.

**25.** Computer program for executing a method for detecting and/or locating faulty data words in a data stream $T_n$, which is designed such that at least the method steps a) and also k), l) and m) according to claim 19 or 20 can be executed.

**26.** Computer program according to claim 25, which is contained on a storage medium, in particular in a computer memory or in a random access memory.

**27.** Computer program according to claim 25, which is transmitted on an electrical carrier signal.

**28.** Data carrier having a computer program according to claim 25.

**29.** Method in which a computer program according to claim 24 is downloaded from an electronic data network such as, by way of example, from the Internet onto a computer connected to the data network.


**Revendications**

**1.** Circuit d'évaluation pour établir et/ou localiser des mots de données défectueux dans un flux de données $T_n$ avec les caractéristiques suivantes :

> - un premier circuit d'automate linéaire (L1) ainsi qu'un second circuit d'automate linéaire (L2) commuté en parallèle avec respectivement une quantité d'états z(t),
> - le premier circuit d'automate linéaire (L1) et le second circuit d'automate linéaire (L2) présentant une ligne d'entrée commune pour recevoir un flux de données $T_n$ formé de n mots de données successifs d'une largeur respective de k bits y (1) , ..., y(n),
> - le premier circuit d'automate linéaire (L1) pouvant être décrit par l'équation suivante :

$$z(t+1) = Az(t) \oplus y(t)$$

> dans laquelle la notation $\oplus$ désigne au plan des composantes une addition modulo 2,

> - le second circuit d'automate linéaire (L2) pouvant être décrit par l'équation suivante :

$$z(t+1) = Bz(t) \oplus y(t)$$

> dans laquelle A et B représentent les matrices d'état des circuits d'automates linéaires (L1, L2), les matrices d'état A et B peuvent être inversées et la dimension L des vecteurs d'état étant $\geq$ k,

> - le premier circuit d'automate linéaire (L1) et le second circuit d'automate linéaire (L2) étant conformés de sorte qu'une première signature (S1) ou une seconde signature (S2) puisse être calculée,
> - des premières portes logiques ($XOR_{L1}$) à aménager en L après le premier circuit d'automate linéaire (L1) ainsi que des secondes portes logiques ($XOR_{L2}$) aménagées en L après le second circuit d'automate linéaire (L2),
> - les portes logiques ($XOR_{L1}$, $XOR_{L2}$) se présentant de sorte que la signature (S1, S2) calculée respectivement par le circuit d'automate linéaire (L1, L2) puisse être comparée à une signature de bonne qualité prédictible et qu'une valeur de comparaison puisse être affichée.

**2.** Circuit d'évaluation selon la revendication 1, **caractérisé en ce que** les portes logiques ($XOR_{L1}$, $XOR_{L2}$) se présentent sous la forme de portes OU exclusives, dont les premières entrées sont raccordées respectivement aux sorties du circuit d'automate linéaire apparenté (L1, L2) et auxquelles les secondes entrées des signatures de bonne qualité peuvent être appliquées.

**3.** Circuit d'évaluation selon la revendication 1 ou 2, **caractérisé en ce que**, devant le premier circuit d'automate linéaire (L1), est aménagé un premier codeur (C1), qui code le mot de données y(i) d'une longueur de mot de données de k bits en un mot de données codé $u^1(i)$, $u^1(i) = Cod1(y(i))$, d'une largeur de mot de K1 bits pour i = 1, ..., n, et dans lequel Cod1 représente la fonction de codage du premier codeur (C1) .

**4.** Circuit d'évaluation selon la revendication 3, **caractérisé en ce qu'**on peut écrire pour la fonction de codage du premier codeur (C1) :

$$\mathrm{Cod1\,(y'\,(i))\ =\ u^1(i)\oplus f_1\ (e(i))}$$

ou

$$\mathrm{Cod1\,(y'\,(i))\ =\ Cod1\,(y\,(i)\oplus e(i))\ =\ Cod1\,(y\,(i)\oplus f_1\ (e(i)))}$$

où, pour y'(i) = y(1)⊕e(i), il existe une fonction $f_1$ avec $f_1(0) = 0$ et il existe une fonction $f_1^{-1}$ avec $f_1^{-1}\,(\mathrm{f_1(e)})\ =\ \mathrm{e}$ pour tous les mots de données binaires e d'une largeur de mot k, qui peuvent se présenter en tant que défauts de mot de données, e désignant un mot de données défectueux du flux de données $T_n$.

**5.** Circuit d'évaluation selon l'une quelconque des revendications 1 à 4, **caractérisé en ce que**, devant le second circuit d'automate linéaire (L2), est aménagé un second codeur (C2), qui code le mot de données y(i) d'une longueur de mot de données de k bits en un mot de données codé $u^2(i)$, $u^2(i)$ Cod2(y(i)) d'une largeur de mot de K2 bits pour i = 1, ..., n, et dans lequel Cod2 représente la fonction de codage du second codeur (C2).

**6.** Circuit d'évaluation selon la revendication 5, **caractérisé en ce que** l'on peut écrire pour la fonction de codage du second codeur (C2) :

$$\mathrm{Cod2\,(y'\,(i))=\ u^2(i)\oplus f_2(e(i))}$$

ou

$$\mathrm{Cod2\,(y'\,(i))=\ Cod2\,(y\,(i)\oplus e(i))}$$
$$\mathrm{=\ Cod2\,(y\,(i))\oplus f_2(e(i))}$$

dans lesquelles il existe une fonction $f_2^{-1}$ avec $f_2^{-1}\,(\mathrm{f_2(e)})\ =\ \mathrm{e}$ pour tous les mots de données binaires e d'une largeur de mot de k, qui peuvent apparaître comme défauts d'un mot de données, e désignant un mot de données défectueux du flux de données $T_n$.

**7.** Circuit d'évaluation selon l'une quelconque des revendications 3 à 6, **caractérisé en ce que** la largeur de mot K1 des mots de données $u^1(i)$ codés par le premier

**8.** Circuit d'évaluation selon l'une quelconque des revendications 3 à 7, **caractérisé en ce que** le premier codeur (C1) coïncide avec le second codeur (C2) en matière de structure et de fonctionnement.

**9.** Circuit d'évaluation selon l'une quelconque des revendications 3 à 8, **caractérisé en ce que** la largeur de mot K1 des mots de données $u^1(i)$ codés par le premier codeur (C1) et la largeur de mot K2 des mots de données $u^2(i)$ codés par le second codeur (C2) sont respectivement égaux à la largeur de mot k des mots de données y(1) , ..., y(n) du flux de données $T_n$.

**10.** Circuit d'évaluation selon l'une quelconque des revendications 3 à 9, **caractérisé en ce que** les fonctions de codage Cod1 et Cod2 du premier codeur (C1) et du second codeur (C2) se présentent comme suit :

$$\text{Cod1}(y_1(i),\ y_2(i),\ \ldots,\ y_k(i))$$
$$=\ \text{P1}(y_1(i),\ y_2(i),\ \ldots,\ y_k(i),\ 0,\ \ldots,\ 0)$$

$$\text{Cod2}(y_1(i),\ y_2(i),\ \ldots,\ y_k(i))$$
$$=\ \text{P2}(y_1(i),\ y_2(i),\ \ldots,\ y_k(i),\ 0,\ \ldots,\ 0)$$

pour i, 1, ..., n

où le nombre de zéros se trouvant à l'extrémité de $P1(y_1(1), y_2(i), ..., y_k(i), 0, ..., 0)$ est égal à (K1-k), le nombre se trouvant à l'extrémité de $P2(y_1(i), y_2(i), ..., y_k(i), 0, ..., 0)$ est égal à (K2-k) et P1 représente une permutation quelconque des K1 composants de $(y_1(i), y_2(i), ..., y_k(i), 0, ..., 0)$ et P2 une permutation quelconque des K2 composants de $(y_1(i), y_2(1), ..., y_k(i), 0, ..., 0)$ .

d'état B du second circuit d'automate linéaire (L2) est égale à la matrice d'état inversée $A^{-1}$ du premier circuit d'automate linéaire (L1).

11. Circuit d'évaluation selon l'une quelconque des revendications 3 à 9, **caractérisé en ce que** les fonctions de codage Cod1 et Cod2 du premier codeur (C1) et du second codeur (C2) se présentent comme suit :

$$\text{Cod1}(y_1(i), y_2(i),\ \ldots,\ y_k(i))$$
$$=\ \text{P1}(y_1(i),\ y_2(i),\ \ldots,\ y_k(i),\ b^1_1 \ldots, b^1_{K1-k})$$

$$\text{Cod2}(y_1(i), y_2(i),\ \ldots,\ y_k(i))$$
$$=\ \text{P2}(y_1(i),\ y_2(i),\ \ldots,\ y_k(i),\ b^2_1 \ldots, b^2_{K2-k})$$

avec
$b^1_1, ...,$
$b^1_{K1-k}, ..., b^2_1, ..., b^2_{K2-k} \in \{0,1\}$ et dans lequel P1 et P2 représentent des permutations quelconques.

12. Circuit d'évaluation selon l'une quelconque des revendications 3 à 11, **caractérisé en ce que** la fonction de codage Cod1 du premier codeur (C1) se présente de manière à réaliser un code de blocage linéaire $f_1$= Cod1.

13. Circuit d'évaluation selon l'une quelconque des revendications 3 à 9 ou selon la revendication 12, **caractérisé en ce que** la fonction de codage Cod2 du second codeur (C2) se présente sous une forme telle qu'elle réalise un code de blocage linéaire $f_2$=Cod2.

14. Circuit d'évaluation selon l'une quelconque des revendications 1 à 13, **caractérisé en ce que** la matrice d'état A du premier circuit d'automate linéaire (L1) et la matrice d'état B du second circuit d'automate linéaire (L2) sont dans un rapport mutuel comme suit :

$$B = A^n$$

avec $n \neq 1$.

**15.** Circuit d'évaluation selon l'une quelconque des revendications 1 à 14, **caractérisé en ce que** la matrice codeur (C1) est égale à la largeur de mot K2 des mots de données $u^2(i)$ codés par le second codeur (C2).

**16.** Circuit d'évaluation selon l'une quelconque des revendications 1 à 15, **caractérisé en ce que** le premier circuit d'automate linéaire (L1) se présente sous la forme de registre à décalage à réinjection linéaire et le second circuit d'automate linéaire (L2) se présente sous la forme de registre à décalage inverse à réinjection linéaire; les deux circuits d'automates linéaires (L1, L2) présentant une entrée parallèle.

**17.** Circuit d'évaluation selon l'une quelconque des revendications 1 à 16, **caractérisé en ce que** le premier circuit d'automate linéaire (L1) se présente sous la forme de registre à décalage à entrés multiples à K1 dimensions et à réinjection linéaire et/ou le second circuit d'automate linéaire (L2) se présente sous la forme de registre à décalage à entrées multiples à K2 dimensions à réinjection linéaire.

**18.** Circuit d'évaluation selon la revendication 17, **caractérisé en ce que** le ou les registres à entrées multiples (L1, L2) présentent un polynôme de réinjection primitif d'une longueur maximale.

**19.** Procédé pour établir et/ou localiser des mots défectueux dans un flux de données $T_n$, dans lequel le procédé présente les étapes suivantes:

a) entrée de mots de données $y(1)$, ..., $y(i-1)$, $y'(i)$, $y(i+1)$, ..., $y(n)$ d'un flux de données $T_n$ dans un premier codeur (C1),
b) codage des mots de données $y(1)$, ..., $y(n)$ en mots de données codés $u^1(1)$, ..., $u^1(n)$ d'une largeur de mot K1 avec $K1 \geq k$ au moyen de la fonction de codage Cod1 du premier codeur (C1),
c) entrée des mots de données codés $u^1(1)$, ..., $u^1(i-1)$, $u^{1'}(i)$ ou $u^1(i)$, $u^1(i)$, ..., $u^1(n)$ dans les entrées d'un premier circuit d'automate linéaire (L1), qui est décrit par l'équation d'automatee :

$$z^1(t+1) = A \cdot z^1(t) + u^1(t)$$

$z^1$ étant un vecteur d'état de K1 dimensions et A étant une matrice d'état K1xK1, et dans laquelle la matrice d'état A peut être inversée,
d) traitement des mots de données codés $u^1(1)$, ..., $u^1(i-1)$, $u^{1'}(i)$ ou $u^1(i)$, $u^1(i)$, ..., $u^1(n)$ par le premier circuit d'automate linéaire (L1), le premier circuit d'automate linéaire (L1)

- passant à l'état $z^1(n+1) = S1(L1, y(1), ..., y(i-1), y(i), y(i+1), ..., y(n))$ lorsque, dans les mots de données codés $u^1(1)$, ..., $u^1(i-1)$, $u^1(i)$, $u^1(i+1)$, ..., $u^1(n)$, on ne peut établir de défaut,
- passant à l'état $z^{1'}(n+1) = S1 (L1, y(1), ..., y(i-1), y'(i), y(i+1), ..., y(n))$ lorsqu'au moins dans la $i^{ème}$ position des mots de données codés $u^1(1)$, ..., $u^1(i-1)$, $u^{1'}(i)$, ..., $u^1(n)$, il y a un défaut,

la signature d'un flux de données sans défaut $T_n$ étant désignée par $S(L1, y(1), ..., y(i-1), y(i), y(i+1), ..., y(n))$ et la signature d'un flux de données défectueux $T_n$ par $S (L1, y(1), ..., y(i-1), y'(i), y(i+1), ..., y(n))$;
e) examen de la signature déterminée du flux de données $T_n$ et poursuite par l'étape de traitement a) pour d'autres flux de données $T_n$, au cas où la signature déterminée du flux de données $T_n$ est la signature d'un flux de données sans défaut $T_n$;
f) entrée des mots de données $y(1)$, ..., $y(i-1)$, $y'(i)$, ..., $y(n)$ du flux de données $T_n$ dans un second codeur (C2);
g) codage des mots de données $y(1)$, ..., $y(i-1)$, $y'(i)$, ..., $y(i+1)$, ..., $y(n)$ en mots de données codés $u^2(1)$, ..., $u^2(i-1)$, $u^{2'}(i)$ ou $u^2(i)$, $u^2(i)$, ..., $u^2(n)$ d'une largeur de mot K2 avec $K2 \geq k$ au moyen de la fonction de codage Cod2 du second codeur (C2);
h) entrée des mots de données codés $u^2(1)$, ..., $u^2(i-1)$, $u^{2'}(i)$ ou $u^2(i)$, $u^2(i)$, ..., $u^2(n)$ dans les entrées d'un second circuit d'automate linéaire (L2), qui est décrit par l'équation d'automatisation :

$$z^2(t+1) = B \cdot z^2(t) \oplus u^2(t)$$

où $z^2$ représente un vecteur d'état de K2 dimensions et B une matrice d'état K2xK2 avec B # A, et où la matrice d'état B peut être inversée;

i) traitement des mots de données codés $u^2(1)$, ..., $u^2(i-1)$, $u^{2'}(i)$ ou $u^2(i)$, $u^2(i)$, ..., $u^2(n)$ par le second circuit d'automate linéaire (L2), le second circuit d'automate linéaire (L2)

- passant à l'état $z^2(n+1) = S2(L2, y(1), ..., y(i-1), y(i), y(i+1), ..., y(n))$ lorsque, dans les mots de données codés $u^2(1)$, ..., $u^2(i-1)$, $u^2(i)$, $u^2(i)$, ..., $u^2(n)$, on ne peut établir de défaut,
- passant à l'état $z^{2'}(n+1) = S2(L2, y(1), ..., y(i-1), y(i), y'(i), y(i+1), ..., y(n))$ lorsqu'au moins dans la i<sup>ème</sup> position des mots de données codés $u^2(1)$, ..., $u^2(i-1)$, $u^{2'}(i)$, $u^2(i)$, ..., $u^2(n)$, il y a un défaut,

la signature d'un flux de données sans défaut $T_n$ étant désignée par $S(L2, y(1), ..., y(i-1), y(i), y(i+1), ..., y(n))$ et la signature d'un flux de données défectueux $T_n$ par $S(L2, y(1), ..., y(i-1), y'(i), ..., y(n))$ ;

j) détermination des différences de signatures $\Delta S1$ et $\Delta S2$ par des portes logiques OU exclusives opérant sur les signatures S1 et S2 déterminées dans l'étape de procédé d) ou i) avec des signatures positives de bonne qualité obtenues, respectivement, selon les dispositions suivantes :

$$\Delta S1 = S(L1, y(1), ..., y(i-1), y(i), y(i+1), ..., y(n))$$
$$\oplus S(L1, y(1), ..., y(i-1), y'(i), y(i+1), ..., y(n))$$

$$\Delta S2 = S(L2, y(1), ..., y(i-1), y(i), y(i+1), ..., y(n))$$
$$\oplus S(L2, y(1), ..., y(i-1), y'(i), y(i+1), ..., y(n))$$

k) détermination d'une solution claire pour la position i du bit défectueux dans le mot de données défectueux par résolution de l'équation :

$$f_1^{-1}(A^{i-n}\Delta S1) = f_2^{-1}(B^{i-n}\Delta S2)$$

au cas où l'on n'obtient aucune solution claire pour $1 \leq i \leq n$, édition d'une communication par un support d'édition indiquant que, dans le flux de données considéré $T_n$, il y a deux défauts ou plus;

l) détermination d'une solution claire pour les nombres e(i) du mot de données défectueux y'(i) dans le flux de données $T_n$ par résolution de l'équation :

$$e(i) = f_1^{-1}(A^{i-n} \cdot \Delta S1)$$

m) édition de la position i du bit défectueux dans le mot de données défectueux ainsi que du défaut e(i) du mot de données défectueux y'(i) dans le flux de données $T_n$ par un support d'édition.

**20.** Procédé selon la revendication 19, **caractérisé en ce que** les étapes du procédé sont réalisées avec un circuit d'évaluation selon une quelconque des revendications 1 à 18.

**21.** Circuit d'évaluation selon l'une quelconque des revendications 1 à 18, **caractérisé en ce que** le circuit d'évaluation est intégré de manière monolithique à un circuit intégré.

22. Carte de charge pour la réception d'au moins une carte à aiguille pour tester des circuits intégrés et/ou avec au moins une douille d'essai pour tester des circuits intégrés et/ou pour raccorder un programme de contrôle sur un testeur de circuits intégrés, dans laquelle la plaque de charge présente un circuit d'évaluation selon l'une quelconque des revendications 1 à 18.

23. Carte à aiguilles pour tester des circuits intégrés, à laquelle un circuit d'évaluation selon l'une quelconque des revendications 1 à 18 a été intégré.

24. Testeur pour tester les circuits intégrés avec les caractéristiques suivantes:

   - le testeur dispose de plusieurs instruments pour produire des signaux ou des flux de données ou de plusieurs capteurs de mesure, en particulier pour des courants et des tensions,
   - le testeur présente une carte de charge qui est prévue pour recevoir au moins une carte à aiguilles pour tester des circuits intégrés et/ou pour raccorder à un programme de contrôle sur un testeur de circuit intégré et/ou qui est équipé d'au moins une douille d'essai pour tester des circuits intégrés; et
   - le testeur présente un circuit d'évaluation selon l'une quelconque des revendications 1 à 18.

25. Programme d'ordinateur pour réaliser un procédé pour établir et/ou localiser des mots de données défectueux dans un flux de données $T_n$, qui se présente sous une forme telle qu'au moins les étapes de procédé a) ainsi que k), l) et m) puissent être réalisées selon la revendication 19 ou 20.

26. Programme d'ordinateur selon la revendication 25, qui est contenu sur un support de mémoire, en particulier dans une mémoire d'ordinateur ou dans une mémoire à accès direct.

27. Programme d'ordinateur selon la revendication 25, qui est transmis à un signal porteur électrique.

28. Support de données avec un programme d'ordinateur selon la revendication 25.

29. Procédé dans lequel un programme d'ordinateur selon la revendication 24 est téléchargé à partir d'un réseau de données électronique, par exemple à partir d'Internet, sur un ordinateur raccordé au réseau de données.

## FIG 1

$T_n$

$k$ → | $y(n)$ | $\cdots$ | $y(2)$ | $y(1)$ | → $k$

11

$S(1 \rightarrow n)$

## FIG 2

$T_n$

$k$ → | $y(n)$ | $\cdots$ | $\begin{array}{c} y'(i) = \\ y(i) \oplus e(i) \end{array}$ | $\cdots$ | $y(2)$ | $y(1)$ | → $k$

11

$S(1 \rightarrow n,i,e)$

## FIG 3

L1

$y_1 \quad\quad y_2 \quad\quad y_3 \quad\quad y_4$

32 → $\oplus$ → $Z_1$ → $\oplus$ → $Z_2$ → $\oplus$ → $Z_3$ → $\oplus$ → $Z_4$ → 30

$XOR_1 \quad\quad XOR_2 \quad\quad XOR_3 \quad\quad XOR_4$

31

## FIG 4

L2

$y_1 \quad\quad y_2 \quad\quad y_3 \quad\quad y_4$

40 ← $Z_1$ ← $\oplus$ ← $Z_2$ ← $\oplus$ ← $Z_3$ ← $\oplus$ ← $Z_4$ ← $\oplus$ ← 42

$XOR_1 \quad\quad XOR_2 \quad\quad XOR_3 \quad\quad XOR_4$

41

FIG 5

$y(1),...,y(i-1),y'(i),y(i+1),...y(n)$

$\sim 51$

5

k

$y(t)$ für $t \neq i$

$y'(i)$

k

$y(t)$ für $t \neq i$

$y'(i)$

C1

C2

$u^1(t)=Cod1(y(t))$ für $t \neq i$

$u^{1'}(i)=Cod1(y'(i))$

$u^2(t)=Cod2(y(t))$ für $t \neq i$

$u^{2'}(i)=Cod2(y'(i))$

K1

K2

L1

L2

$L \mid z^{1'}(n+1)=S(L1,u^1(1),..., u^{1'}(i),...,u^1(n))$

$L \mid z^{2'}(n+1)=S(L2,u^2(1),..., u^{2'}(i),...,u^2(n))$

$XOR_{L1}$

$z^1(n+1)=S(L1,u^1(1),..., u^1(i),...,u^1(n))$

$XOR_{L2}$

$z^2(n+1)=S(L2,u^2(1),..., u^2(i),...,u^2(n))$

L

L

$52 \sim \mid L$

$\Delta S1$

$53 \sim \mid L$

$\Delta S2$

## FIG 6

```
                    ┌─────────┐
                    │  Start  │
                    └─────────┘
                         │
                         ▼                    6
        ┌──────────────────────────────┐
        │  Erzeugen eines Datenstroms   │──── 61
        │    Tn mit ΔS1 und ΔS2         │◄───────┐
        └──────────────────────────────┘        │
                         │                       │
                         ▼          62           │
                    ╱─────────╲                  │
                   ╱  ΔS1 ≠ 0  ╲    nein          │
                   ╲    ?       ╱────────────────┘
                    ╲─────────╱
                         │ ja
                         ▼
        ┌──────────────────────────────┐
        │   Setze MILFSR zurück auf     │──── 63
        │      ΔS1 und ΔS2              │
        └──────────────────────────────┘
                         │
                         ▼
        ┌──────────────────────────────┐
        │  Rechne zurück für y(t) = 0̄   │──── 64
        └──────────────────────────────┘
                         │
                         ▼          65
                    ╱─────────╲              ┌──────────────────┐
                   ╱ Existiert  ╲   nein      │   mehr als ein   │──── 67
                   ╲  eine       ╱───────────►│  Datenwort i falsch │
                   ╲  Lösung ?  ╱             └──────────────────┘
                    ╲─────────╱                       │
                         │ ja                         │
                         ▼                            │
        ┌──────────────────────────────┐             │
        │   Datenwort i, Fehler e       │──── 66      │
        └──────────────────────────────┘             │
                         │◄───────────────────────────┘
                         ▼
                    ┌─────────┐
                    │   Ende  │
                    └─────────┘
```